(19) Europäisches Patentamt
European Patent Office
Office européen des brevets

(11) EP 1 231 619 A2

(12) EUROPEAN PATENT APPLICATION

(43) Date of publication:
14.08.2002 Bulletin 2002/33

(51) Int Cl.[7]: H01G 9/20

(21) Application number: 02003331.2

(22) Date of filing: 13.02.2002

(84) Designated Contracting States:
AT BE CH CY DE DK ES FI FR GB GR IE IT LI LU MC NL PT SE TR
Designated Extension States:
AL LT LV MK RO SI

(30) Priority: 13.02.2001 JP 2001035955

(71) Applicant: Fuji Photo Film Co., Ltd.
Kanagawa-ken (JP)

(72) Inventor: Watanabe, Tetsuya
Minami-Ashigara-shi, Kanagawa-ken (JP)

(74) Representative: Patentanwälte Dr. Solf & Zapf
Candidplatz 15
81543 München (DE)

# (54) Metal complex dye for a photoelectrochemical cell

(57) A photoelectric conversion device comprising a semiconductor fine particle sensitized by a metal complex dye, wherein the metal complex dye comprises a bidentate or tridentate ligand represented by the following general formula (II):

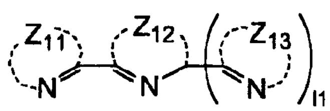

· · · (II)

wherein $Z_{11}$, $Z_{12}$ and $Z_{13}$ independently represent non-metallic atoms forming a 5- or 6-membered ring, the 5- or 6-membered ring optionally has a substituent and optionally forms a condensed ring in combination with another ring, at least one of $Z_{11}$ and $Z_{12}$ forms a pyridine ring or a condensed ring comprising a pyridine ring that has a plurality of acidic groups, and 11 represents 0 or 1.

Fig. 1

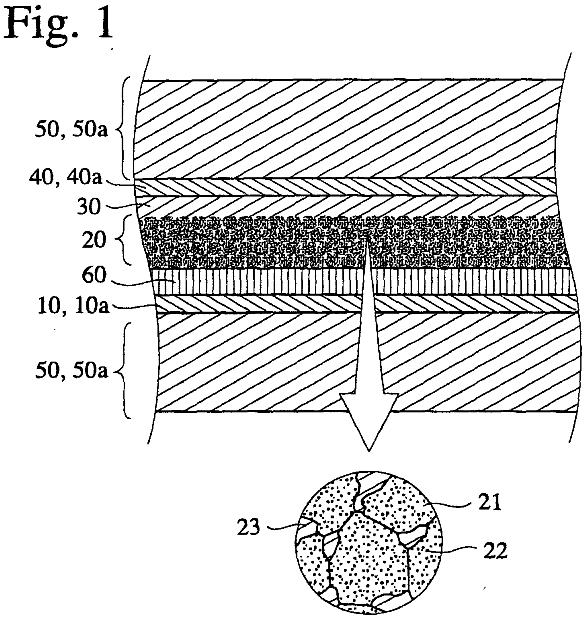


EP 1 231 619 A2

## Description

FIELD OF THE INVENTION

The present invention relates to a photoelectric conversion device comprising a semiconductor fine particle sensitized by a dye, a photoelectric cell using the photoelectric conversion device, and a metal complex dye usable therefor.

BACKGROUND OF THE INVENTION

To put solar power generation into practical use, solar cells utilizing monocrystalline silicon, polycrystalline silicon, amorphous silicon, cadmium telluride, indium copper selenide, etc. have been mainly researched and developed. However, such problems as high production cost, difficulty in security of raw materials and a long energy payback time must be overcome for a widespread use of the solar cells as a home power source, etc. Although a variety of solar cells using an organic material also have been proposed with the objects of increasing surface area and reducing costs, such solar cells have disadvantages of low conversion efficiency and poor durability.

Under such circumstances, Nature, Vol. 353, Page 737 to 740 (1991), United States Patent No. 4,927,721, WO 94/04497, etc. have disclosed photoelectric conversion devices and solar cells comprising a semiconductor fine particle sensitized by a dye, and materials and production methods therefor. The photoelectric conversion devices are a wet-type devices using a titanium dioxide porous thin film spectrally sensitized by a ruthenium complex dye as a working electrode. The primary advantage for the wet-type photoelectric conversion devices is that they can be produced with low costs because they can use an inexpensive metal oxide semiconductor such as titanium dioxide without purification to a high purity. The secondary advantage is that the wet-type photoelectric conversion devices can convert light in almost entire visible wavelength region to electricity because the dye used therein has a broad absorption spectrum.

In such wet-type photoelectric conversion devices and solar cells, open circuit voltage theoretically depends on a conduction band of the oxide semiconductor and redox level of an electrolyte. For example, theoretical open circuit voltage is approximately 1.1 V or more when titanium oxide is used as the oxide semiconductor and $I^-/I_3^-$ is used as the electrolyte. However, such a high open circuit voltage has not been reported, thus, it has been hoped to improve the open circuit voltage to increase the photoelectric conversion efficiency of the photoelectric conversion device and the solar cell.

OBJECT AND SUMMARY OF THE INVENTION

An object of the present invention is to provide a dye-sensitized photoelectric conversion device exhibiting a high open circuit voltage, a photoelectric cell using the photoelectric conversion device, and a metal complex dye useful therefor.

As a result of intense research in view of the above object, the inventor has found that a photoelectric conversion device using a particular metal complex dye with a plurality of acidic groups exhibits a high open circuit voltage. The present invention has been accomplished by the finding.

Thus, a photoelectric conversion device of the present invention comprises a semiconductor fine particle sensitized by a metal complex dye, wherein the metal complex dye is represented by the following general formula (I):

$$M(L1)_{m1}(L2)_{m2}(L3)_{m3} \cdot Cl \qquad (I)$$

wherein M is a metal atom;

L1 is a bidentate or tridentate ligand represented by the following general formula (II):

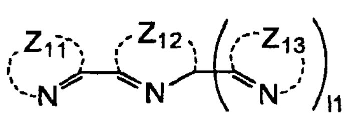

. . . (II)

wherein $Z_{11}$, $Z_{12}$ and $Z_{13}$ independently represent non-metallic atoms forming a 5- or 6-membered ring, the 5- or 6-membered ring optionally has a substituent and optionally forms a condensed ring in combination with another ring, at least one of $Z_{11}$ and $Z_{12}$ forms a pyridine ring or a condensed ring comprising a pyridine ring that has a plurality of acidic groups, and 11 represents 0 or 1;
L2 is a bidentate or tridentate ligand represented by the following general formula (III):

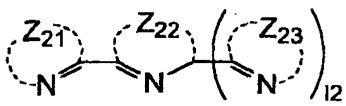

· · · (III)

wherein $Z_{21}$, $Z_{22}$ and $Z_{23}$ independently represent non-metallic atoms forming a 5- or 6-membered ring, the 5- or 6-membered ring optionally has a substituent and optionally forms a condensed ring in combination with another ring, and 12 represents 0 or 1;
L3 is a monodentate or bidentate ligand;
m1 is an integer of 1 to 3;
m2 is an integer of 0 to 2;
m3 is an integer of 0 to 4; and
CI is a counter ion optionally contained in the metal complex dye to neutralize charge thereof.

A photoelectric cell of the present invention comprises the above photoelectric conversion device of the present invention.
In the present invention, the open circuit voltage of the photoelectric conversion device and the photoelectric cell is further improved by satisfying any of the following conditions (1) to (5).

(1) M is particularly preferably Ru.
(2) m2 is preferably 0, and it is particularly preferred that ml is 2 and m2 is 0.
(3) A carboxyl group is particularly preferred as the acidic group.
(4) L3 is particularly preferably NCS.
(5) The semiconductor fine particle is particularly preferably a titanium oxide fine particle.

A ruthenium complex dye represented by the following general formula (IV) can be preferably used for the photoelectric conversion device and the photoelectric cell according to the present invention.

$$Ru(L4)_{m1}(L2)_{m2}(L3)_{m3} \cdot CI \qquad (IV)$$

In the general formula (IV), L4 is a bidentate or tridentate ligand represented by the following general formula (V):

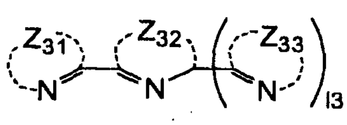

· · · (V)

wherein $Z_{31}$, $Z_{32}$ and $Z_{33}$ independently represent non-metallic atoms forming a 5- or 6-membered ring, the 5- or 6-membered ring optionally has a substituent and optionally forms a condensed ring in combination with another ring, at least one of $Z_{31}$ and $Z_{32}$ forms a pyridine ring having a plurality of carboxyl groups, and 13 represents 0 or 1; and L2, L3, m1, m2, m3 and CI have the same meaning as in the general formula (I), respectively.

BRIEF DESCRIPTION OF THE DRAWINGS

Fig. 1 is a partial cross sectional view showing a preferable structure of a photoelectric conversion device of the present invention;
Fig. 2 is a partial cross sectional view showing a preferable structure of the photoelectric conversion device of the present invention;
Fig. 3 is a partial cross sectional view showing a preferable structure of the photoelectric conversion device of the present invention;
Fig. 4 is a partial cross sectional view showing a preferable structure of the photoelectric conversion device of the present invention;
Fig. 5 is a partial cross sectional view showing a preferable structure of the photoelectric conversion device of the present invention;
Fig. 6 is a partial cross sectional view showing a preferable structure of the photoelectric conversion device of the present invention;
Fig. 7 is a partial cross sectional view showing a preferable structure of the photoelectric conversion device of the present invention;
Fig. 8 is a partial cross sectional view showing a preferable structure of the photoelectric conversion device of the present invention;
Fig. 9 is a partial cross sectional view showing a preferable structure of the photoelectric conversion device of the present invention; and
Fig. 10 is a partial cross sectional view showing a photoelectric conversion device produced in EXAMPLES.

DETAILED DESCRIPTION OF THE PREFERRED EMBODIMENTS

[1] Metal Complex Dye

A metal complex dye used for a photoelectric conversion device of the present invention is represented by the following general formula (I).

$$M(L1)_{m1}(L2)_{m2}(L3)_{m3} \cdot Cl \qquad (I)$$

The metal complex dye represented by the general formula (I) will be described in detail below. Incidentally, if the metal complex dye comprises an alkyl group, an alkenyl group, an alkynyl group, an alkylene group, etc., these groups may have a straight or branched structure and may be substituted or unsubstituted. Further, when the metal complex dye comprises an aryl group, a heterocyclic group, a cycloalkyl group, etc., these groups may have a monocyclic structure or a polycyclic structure such as a condensed ring and a ring assemblage, and may be substituted or unsubstituted.

(A) Metal Atom M

In the general formula (I), M is a metal atom. M is preferably such a metal atom that can form a four- or six-coordinated complex, more preferably Ru, Fe, Os, Cu, W, Cr, Mo, Ni, Pd, Pt, Co, Ir, Rh, Re, Mn or Zn, furthermore preferably Ru, Fe or Os, particularly preferably Ru.

(B) Ligand L1

In the general formula (I), L1 is a bidentate or tridentate ligand represented by the following general formula (II).

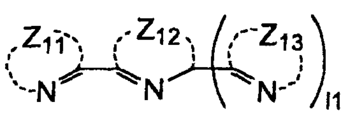

· · · (II)

ml indicating the number of L1 is an integer of 1 to 3, preferably 1 or 2, more preferably 2.

In the general formula (II), $Z_{11}$, $Z_{12}$ and $Z_{13}$ represent non-metallic atoms forming a 5- or 6-membered ring, respectively. The 5- or 6-membered ring may have a substituent and may form a condensed ring in combination with another ring. $Z_{11}$, $Z_{12}$ and $Z_{13}$ are preferably composed of atoms selected from the group consisting of carbon, hydrogen, nitrogen, oxygen, sulfur, phosphorus and halogen atoms, respectively. The 5- or 6-membered ring is preferably an aromatic ring. The 5-membered ring is preferably an imidazole ring, an oxazole ring, a thiazole ring or a triazole ring. The 6-membered ring is preferably a pyridine ring, a pyrimidine ring, a pyridazine ring or a pyrazine ring. Of these rings, more preferred are an imidazole ring and a pyridine ring, particularly preferred is a pyridine ring.

At least one of $Z_{11}$ and $Z_{12}$ forms a ring having a plurality of acidic groups, the ring being a pyridine ring or a condensed ring comprising a pyridine ring. In the present invention, "acidic group" means such a group that exhibits a pKa value of 14 or less and that can release a dissociative hydrogen atom to be an anion. The plurality of acidic groups may be the same or different each other. The acidic group may be selected from the group consisting of a carboxyl group, phosphonyl groups, phosphoryl groups, silicic acid groups, a hydroxyl group, sulfonic acid groups and boric acid groups, etc. The acidic group is preferably a carboxyl group, a hydroxyl group or a sulfonic acid group, particularly preferably a carboxyl group.

In the general formula (II), 11 represents 0 or 1.

Examples of the ligand of L1 will be illustrated below without intention of restricting the scope of the present invention defined by the claims attached hereto.

L1-1

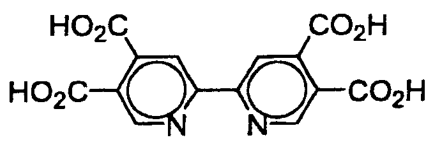

L1-2

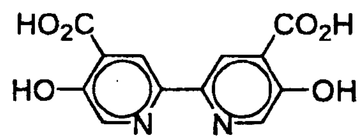

L1-3

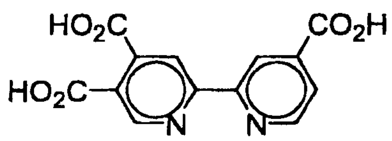

L1-4

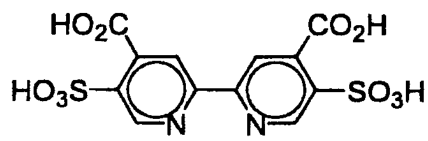

L1-5

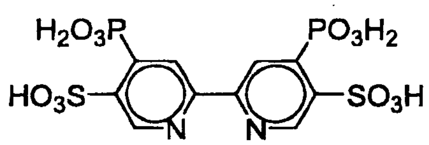

L1-6

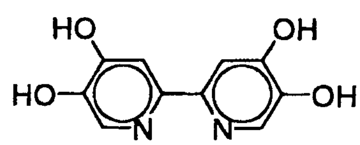

L1-7

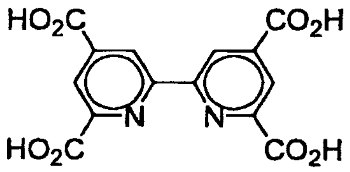

L1-8

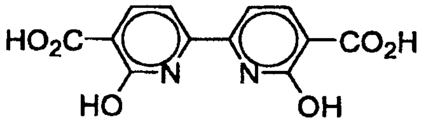

L1-9

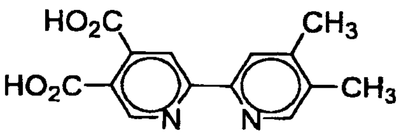

L1-10

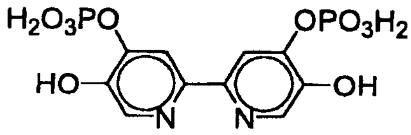

L1-11

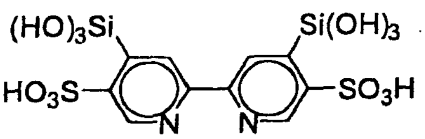

L1-12

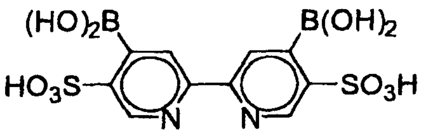

L1-13

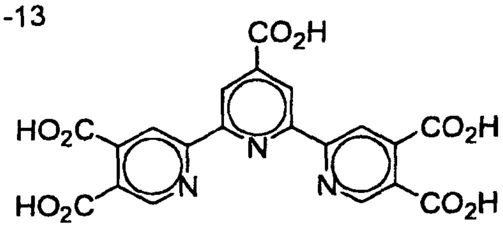

L1-14

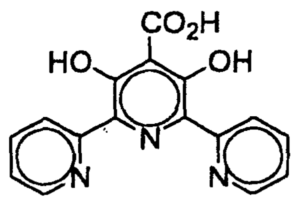

L1-15

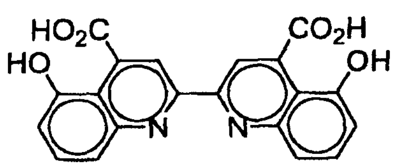

L1-16

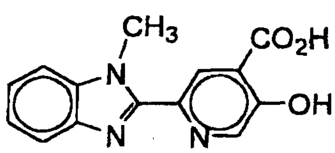

L1-17

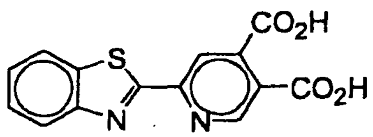

L1-18

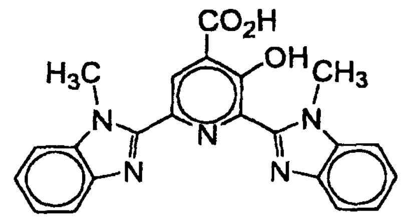

(C) Ligand L2

In the general formula (I), L2 is a bidentate or tridentate ligand represented by the following general formula (III).

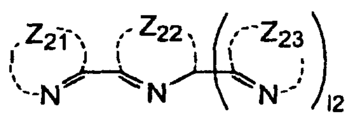

· · · (III)

m2 indicating the number of L2 is an integer of 0 to 2, preferably 0.

In the general formula (III), $Z_{21}$, $Z_{22}$ and $Z_{23}$ represent non-metallic atoms forming a 5- or 6-membered ring, respectively. The 5- or 6-membered ring may have a substituent and may form a condensed ring in combination with another ring. $Z_{21}$, $Z_{22}$ and $Z_{23}$ are preferably composed of atoms selected from the group consisting of carbon, hydrogen, nitrogen, oxygen, sulfur, phosphorus and halogen atoms, respectively. The 5- or 6-membered ring is preferably an aromatic ring. The 5-membered ring is preferably an imidazole ring, an oxazole ring, a thiazole ring or a triazole ring. The 6-membered ring is preferably a pyridine ring, a pyrimidine ring, a pyridazine ring or a pyrazine ring. Of these rings, more preferred are an imidazole ring and a pyridine ring, particularly preferred is a pyridine ring.

In the general formula (III), 12 represents 0 or 1.

Examples of the ligand of L2 will be illustrated below without intention of restricting the scope of the present invention defined by the claims attached hereto.

L2-1

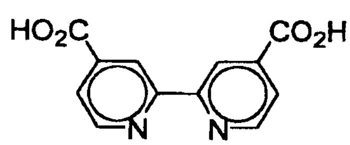

L2-2

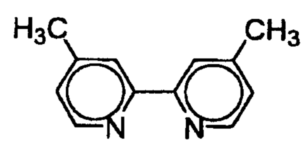

L2-3

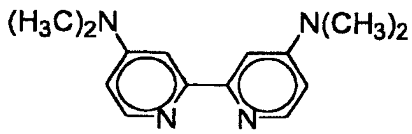

L2-4

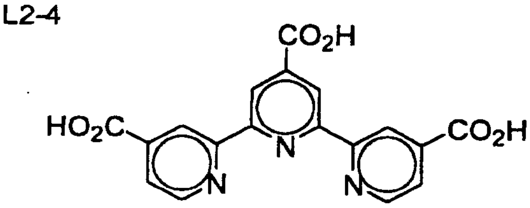

L2-5

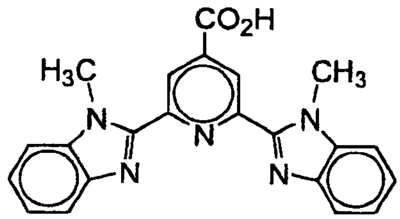

(D) Ligand L3

In the general formula (I), L3 is a monodentate or bidentate ligand. m3 indicating the number of L3 is an integer of 0 to 4. When m3 is 2 or more, a plurality of L3's may be the same or different ligands that may bond together.

Examples of L3 include monodentate or bidentate ligands that coordinate to the metal atom via one or two group selected from the group consisting of: acyloxy groups preferably having 1 to 20 carbon atom such as an acetyloxy group, a benzoyloxy group and an oxalylene group (-OC(O)C(O)O-); acylthio groups preferably having 1 to 20 carbon atom such as an acetylthio group and a benzoylthio group; acylaminoxy groups preferably having 1 to 20 carbon atom such as an *N*-methylbenzoylaminoxy group ($PhC(O)N(CH_3)O$-) and an acetylaminoxy group ($CH_3C(O)NHO$-); thioacyloxy groups preferably having 1 to 20 carbon atom such as a thioacetyloxy group ($CH_3C(S)O$-); thioacylthio groups preferably having 1 to 20 carbon atom such as a thioacetylthio group ($CH_3C(S)S$-) and a thiobezoylthio group (PhC(S)S-); thiocarbonate groups preferably having 1 to 20 carbon atom such as an ethylthiocarbonate group ($C_2H_5OC(S)O$-) and a phenylthiocarbonate group (PhOC(S)O-); dithiocarbonate groups preferably having 1 to 20 carbon atom such as an ethyldithiocarbonate group ($C_2H_5OC(S)S$-); trithiocarbonate groups preferably having 1 to 20 carbon atom such as an ethyltrithiocarbonate group ($C_2H_5SC(S)S$-) and a phenyltrithiocarbonate group (PhSC(S)S-); alkylthio groups preferably having 1 to 20 carbon atom such as a methylthio group and an ethylenedithio group; arylthio groups preferably having 6 to 20 carbon atoms such as a benzenethio group and a 1,2-phenylenedithio group; alkoxy groups preferably having 1 to 20 carbon atom such as a methoxy group and an ethylenedioxy group; aryloxy groups preferably having 6 to 20 carbon atoms such as a phenoxy group and a 1,2-benzenedioxy group; an isocyanate group; a cyanate group; an isothiocyanate group; and a thiocyanate group.

Examples of L3 further include: dialkylketones preferably having 3 to 20 carbon atoms such as dimethyl ketone ($(CH_3)_2CO\cdots$); carbonamides preferably having 1 to 20 carbon atom such as $CH_3N=C(CH_3)O$- and -OC(=NH)-C(-NH)O-; thiocarbonamides preferably having 1 to 20 carbon atom such as $CH_3N=C(CH_3)S$-; thioureas preferably having 1 to 20 carbon atom; isothioureas preferably having 1 to 20 carbon atom; halogen atoms; water; β-diketonato ligands preferably having 3 to 20 carbon atoms such as $CH_3C(O\cdots)CH=C(O-)CH_3$; β-dithioketonato ligands preferably having 3 to 20 carbon atoms such as $CH_3C(S\cdots)CH=C(S-)CH_3$; β-ketothionato ligands preferably having 3 to 20 carbon atoms such as $CH_3C(O\cdots)CH=C(S-)CH_3$; and β-thionketonato ligands preferably having 3 to 20 carbon atoms such as $CH_3C(S\cdots)CH=C(O-)CH_3$. Incidentally, "···" represents a coordinate bond.

L3 is preferably a ligand that coordinates to the metal atom via an isocyanate group, a cyanate group, an isothiocyanate group or a thiocyanate group, or a ligand of a halogen atom, particularly preferably a ligand that coordinates via an isothiocyanate group.

(E) Counter Ion CI

In the general formula (I), CI is a counter ion optionally contained in the metal complex dye to neutralize charge of the dye. Whether the metal complex dye is cationic or anionic and whether the metal complex dye has an ionic charge or not without the counter ion depend on the metal atom, the ligand(s) and the substituent(s) thereof. When the metal complex dye comprises a dissociative group, it may be dissociated so that the metal complex dye has a charge. In such a case, the charge may be neutralized by CI.

Typical examples of a positive counter ion represented by CI include: inorganic and organic ammonium ions such as tetralkyl ammonium ions and a pyridinium ion; alkali metal ions; etc. A negative counter ion represented by CI may be inorganic or organic, and examples thereof include: halide ions such as a fluoride ion, a chloride ion, a bromide ion and an iodide ion; substituted aryl sulfonate ions such as a *p*-toluene sulfonate ion and a *p*-chlorobenzene sulfonate ion; aryl disulfonate ions such as a 1,3-benzene disulfonate ion, a 1,5-naphthalene disulfonate ion and a 2,6-naphthalene disulfonate ion; alkyl sulfate ions such as a methyl sulfate ion; a sulfate ion; a thiocyanate ion; a perchlorate ion;

a tetrafluoroborate ion; a hexafluorophosphate ion; a picrate ion; an acetate ion; a trifluoromethane sulfonate ion; etc. Further, the counter ion may be a charge-balancing counter ion such as an ionic polymer and another dye having a charge opposite to that of the metal complex dye of the general formula (I). Metal complex ion such as bisbenzene-1,2-dithiolato nickel (III) may be used as the counter ion.

(F) Examples of Metal Complex Dye

Examples of the metal complex dye used in the present invention will be illustrated below without intention of restricting the scope of the present invention defined by the claims attached hereto.

$Ru(L1)_{m1}(L2)_{m2}(L3)_{m3}$

| | L1 | m1 | L2 | m2 | L3 | m3 |
|---|---|---|---|---|---|---|
| D-1 | L1-1 | 2 | — | — | NCS | 2 |
| D-2 | L1-1 | 1 | L2-1 | 1 | NCS | 1 |
| D-3 | L1-2 | 2 | — | — | NCS | 2 |
| D-4 | L1-3 | 2 | — | — | NCS | 2 |
| D-5 | L1-4 | 2 | — | — | NCS | 2 |
| D-6 | L1-5 | 3 | — | — | — | — |
| D-7 | L1-11 | 2 | — | — | NCS | 2 |
| D-8 | L1-13 | 1 | L2-3 | 1 | Cl | 1 |

D-9

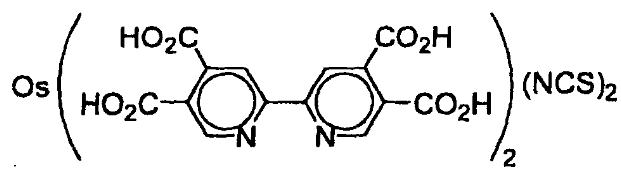

D-10

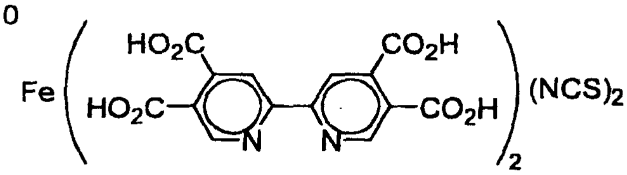

[2] Photoelectric Conversion Device

A photoelectric conversion device of the present invention has a photosensitive layer comprising a semiconductor fine particle sensitized by a metal complex dye of the general formula (I).

As shown in Fig. 1, the photoelectric conversion device of the present invention preferably comprises: an electrically conductive layer 10; a photosensitive layer 20 containing semiconductor fine particles 21 sensitized by the dyes 22 and an charge-transporting material 23 penetrated into voids among the particles; a charge transfer layer 30; and a counter electrically conductive layer 40 laminated in this order. An undercoating layer 60 may be disposed

between the electrically conductive layer 10 and the photosensitive layer 20. The charge-transporting material 23 is generally the same as the material used for the charge transfer layer 30. On the electrically conductive layer 10 and/or the counter electrically conductive layer 40 may be disposed a substrate 50 to improve the strength of the photoelectric conversion device. In the present invention, a layer composed of the electrically conductive layer 10 and the substrate 50 disposed thereon if necessary is referred to as "conductive support", and a layer composed of the counter electrically conductive layer 40 and the substrate 50 disposed thereon if necessary is referred to as "counter electrode". Incidentally, the electrically conductive layer 10, the counter electrically conductive layer 40 and the substrate 50 shown in Fig. 1 may be a transparent electrically conductive layer 10a, a transparent counter electrically conductive layer 40a and a transparent substrate 50a, respectively.

A photoelectric cell is constituted by connecting the photoelectric conversion device to an external circuit to electrically work or generate electricity in the external circuit. A photosensor is such a photoelectric conversion device for sensesing optical information. Such a photoelectric cell that has the charge transfer layer composed of an ion conductive material is referred to as a photo-electrochemical cell. A photoelectric cell intended for power generation using solar light is referred to as a solar cell.

In the photoelectric conversion device shown in Fig. 1, in the case of using *n*-type semiconductor fine particles, a light injected to the photosensitive layer 20 excites the dyes 22, etc., excited high energy electrons therein are transported to a conduction band of the semiconductor fine particles 21, and they are diffused to reach to the electrically conductive layer 10. At this time, the dyes 22 are in oxidized form. In a photoelectric cell composed of the photoelectric conversion device, electrons in the electrically conductive layer 10 are returned to the oxidized dyes through the counter electrically conductive layer 40 and the charge transfer layer 30 while working in the external circuit, so that the dyes 22 are regenerated. The photosensitive layer 20 generally acts as a negative electrode (or a photoanode), and the counter electrically conductive layer 40 generally acts as a positive electrode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., contents of each layer may be diffused and mixed.

Each layer comprised in the photoelectric conversion device of the present invention will be explained in detail below.

(A) Conductive Support

The conductive support is composed of (1) a single layer of the electrically conductive layer, or (2) two layers of the electrically conductive layer and the substrate. In the case of (1), the electrically conductive layer is preferably made of a material having a sufficient strength that can sufficiently seal the photoelectric conversion device, for example, a metal such as platinum, gold, silver, copper, zinc, titanium, aluminum and an alloy composed thereof. In the case of (2), the substrate on which the electrically conductive layer containing an electrically conductive material is provided at the photosensitive layer side may be used as the conductive support. Preferable examples of the electrically conductive material include: metals such as platinum, gold, silver, copper, zinc, titanium, aluminum, indium and alloys composed thereof; carbon; electrically conductive metal oxides such as indium-tin composite oxides and tin oxides doped with fluorine or antimony; etc. The electrically conductive layer preferably has a thickness of 0.02 to 10 μm.

The surface resistance of the conductive support is desirable as low as possible. The surface resistance is preferably 50 Ω/square or less, more preferably 20 Ω/square or less.

When light is irradiated from the conductive support side, it is preferred that the conductive support is substantially transparent. Herein, the term "being substantially transparent" means that the light transmittance is 10 % or more. The light transmittance is preferably 50 % or more, more preferably 70 % or more.

The transparent conductive support is preferably constituted by disposing the transparent electrically conductive layer of an electrically conductive metal oxide on the transparent substrate of such material as a glass and a plastic by means of coating or vapor deposition. The transparent electrically conductive layer is preferably made of tin dioxide doped with fluorine or antimony, or indium-tin oxide (ITO). The transparent substrate may be made of a glass such as a low-cost soda glass excellent in strength and a non-alkali glass that causes no alkaline elution. Additionally, a transparent polymer film is preferably used as the transparent substrate. Used as the materials for the transparent polymer film may be tetracetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyimide (PI), polyetherimide (PEI), cyclic polyolefin, brominated phenoxy resin, etc. To secure a sufficient transparency, the coating amount of the electrically conductive metal oxide is preferably 0.01 to 100 g per 1 $m^2$ of the glass or plastic substrate.

It is preferable that a metal lead is used to reduce the resistance of the transparent conductive support. The metal lead is preferably made of a metal such as platinum, gold, nickel, titanium, aluminum, copper, silver, etc. It is preferable that the metal lead is provided on the transparent substrate by a vapor deposition method, a sputtering

method, etc., the transparent electrically conductive layer of conductive tin oxide or ITO being disposed thereon. The reduction in incident light quantity owing to the metal lead is suppressed to preferably 10 % or less, more preferably 1 to 5 %.

(B) Photosensitive Layer

The photosensitive layer comprises the semiconductor fine particle sensitized by the metal complex dye represented by the general formula (I). In the photosensitive layer, the semiconductor fine particle acts as a photosensitive substance to absorb a light and conduct charge separation, thereby generating electrons and positive holes. In the dye-sensitized semiconductor fine particle, the light absorption and the generation of the electrons and the positive holes are primarily caused in the dye, and the semiconductor fine particle receives and conveys the electrons or the positive holes.

(1) Semiconductor

Used as the semiconductor may be: an elementary substance semiconductor such as silicon and germanium; a III-V series compound semiconductor; a metal chalcogenide such as a metal oxide, a metal sulfide, a metal selenide and a composite thereof; a compound having a perovskite structure such as strontium titanate, calcium titanate, sodium titanate, barium titanate and potassium niobate; etc. An *n*-type semiconductor is preferably used in the present invention, in which conductor electrons act as a carrier under photo-excitation condition to provide anode current.

Preferable examples of the metal chalcogenide include: oxides of titanium, tin, zinc, iron, tungsten, zirconium, hafnium, strontium, indium, cerium, yttrium, lanthanum, vanadium, niobium or tantalum; sulfides of cadmium, zinc, lead, silver, antimony or bismuth; selenides of cadmium or lead; cadmium telluride; etc. Additionally, compound semiconductors such as phosphides of zinc, gallium, indium or cadmium, selenides of gallium-arsenic or copper-indium, copper-indium sulfide, etc. may be used in this invention. Further, composite semiconductors such as $M_xO_yS_z$ and $M_{1x}M_{2y}O_z$ are also preferably used in the present invention, in which M, $M_1$ and $M_2$ independently represent a metal atom, O represents an oxygen atom, S represents a sulfur atom, and x, y and z represent numbers combined with each other to form a neutral molecule.

Preferable specific examples of the semiconductor include Si, $TiO_2$, $SnO_2$, $Fe_2O_3$, $WO_3$, ZnO, $Nb_2O_5$, CdS, ZnS, PbS, $Bi_2S_3$, CdSe, CdTe, $SrTiO_3$, GaP, InP, GaAs, $CuInS_2$ and $CuInSe_2$. Of these semiconductors, more preferred are $TiO_2$, $SnO_2$, $Fe_2O_3$, $WO_3$, ZnO, $Nb_2O_5$, CdS, PbS, CdSe, $SrTiO_3$, InP, GaAs, $CuInS_2$ and $CuInSe_2$, furthermore preferred are $TiO_2$ and $Nb_2O_5$, and particularly preferred is $TiO_2$. $TiO_2$ contains anatase-type crystal structure of preferably 70 volume % or more, particularly preferably 100 volume %. It is preferable that the semiconductor is doped with a metal to increase electron conductivity thereof. This metal is preferably divalent or trivalent. Further, the semiconductor is preferably doped with a monovalent metal to prevent a reverse current from the semiconductor to the charge transfer layer.

The semiconductor may have a single crystal or poly crystal structure. The poly crystal semiconductor is preferred from the viewpoints of the production costs, security of the raw materials, the energy-payback time, etc. The photosensitive layer is particularly preferably a porous semiconductor fine particle layer. The photosensitive layer may partly contain an amorphous semiconductor.

The particle size of the semiconductor fine particle is generally in the nm to μm level. The average size of primary semiconductor particles, which is obtained from a diameter of a circle equivalent to a projected area thereof, is preferably 5 to 200 nm, more preferably 8 to 100 nm. Further, the average size of secondary semiconductor particles in dispersion is preferably 0.01 to 30 μm.

Two or more of the semiconductor fine particles having a different particle size distribution may be mixed to use for the photosensitive layer. In this case, the average particle size of the smaller particles is preferably 25 nm or less, more preferably 10 nm or less. To improve a light-capturing rate of the photoelectric conversion device by scattering ray of incident light, the semiconductor fine particles having a large particle size, e.g. approximately 100 to 300 nm in diameter, may be used for the photosensitive layer.

Two or more kinds of the semiconductor fine particles may be mixed and used for the photosensitive layer. In this case, it is preferable that one is $TiO_2$, ZnO, $Nb_2O_5$ or $SrTiO_3$ and the other is $SnO_2$, $Fe_2O_3$ or $WO_3$. More preferred combination is ZnO and $SnO_2$, ZnO and $WO_3$, ZnO and $SnO_2$ and $WO_3$, etc. Each of the semiconductor fine particles may have a different diameter. Particularly preferred is a combination of $TiO_2$, ZnO, $Nb_2O_5$ or $SrTiO_3$ having a larger diameter and $SnO_2$, $Fe_2O_3$ or $WO_3$ having a smaller diameter, the larger diameter being preferably 100 nm or more, and the smaller diameter being preferably 15 nm or less.

Preferred as a method for producing the semiconductor fine particle are: sol-gel methods described in Sumio Sakka, "Zoru-Geru-Ho No Kagaku (Science of Sol-Gel Method)", Agune Shofusha (1998), Technical Information Association, "Zoru-Geru-Ho Niyoru Hakumaku Coating Gijutu (Thin Film-Coating Technology by Sol-Gel Method)" (1995),

etc.; and gel-sol methods described in Tadao Sugimoto, "Shin-Goseiho Geru-Zoru-Ho Niyoru Tanbunsanryusi No Gosei To Saizu-Keitaiseigyo (Synthesis of Mono-Dispersion Particles and Control of Their Size and Form by Novel Gel-Sol Method)", and MATERIA, Vol. 35, No. 9, Page 1012 to 1018 (1996). The method developed by Degussa Company, which comprises preparing oxides by subjecting chlorides to a high temperature hydrolysis in an oxyhydrogen salt, is also preferred.

In the case of using the semiconductor fine particle of titanium oxide, any of the above-described sol-gel methods, gel-sol methods and high temperature hydrolysis method are preferably used, further, a sulfuric acid method and a chlorine method described in Manabu Seino, "Sanka-Chitan Bussei To Ouyougijutu (Titanium oxide - Properties and Applied Technique)", Gihodo Shuppan, (1997) may be used. Of the sol-gel methods, also preferred are such that described in Christophe J. Barb'e, et al, Journal of American Ceramic Society, Vol. 80, No. 12, Page 3157 to 3171 (1997) and Burnside, et al, Chemistry of Materials, Vol. 10, No. 9, Page 2419 to 2425.

(2) Semiconductor Fine Particle Layer

The semiconductor fine particles may be applied onto the conductive support by: a method where the conductive support is coated with a dispersion or a colloidal solution containing the particles; the above-mentioned sol-gel method; etc. A wet type film production method is relatively advantageous for the mass production of the photoelectric conversion device, improvement of properties of the semiconductor fine particle solution, improvement of the adaptability of the conductive support, etc. As such a wet type film production method, coating methods, printing methods, electrolytic deposition methods and electrodeposition techniques are typical examples. Further, the semiconductor fine particle layer may be disposed by: oxidizing a metal; an LPD method where a metal solution is subjected to ligand exchange, etc.; a sputtering method; a vapor deposition method; a CVD method; or an SPD method where a thermal decomposition-type metal oxide precursor is sprayed on a heated substrate to generate a metal oxide.

The dispersion containing the semiconductor fine particles may be prepared by: the sol-gel methods mentioned above; crushing the semiconductor in a mortar; dispersing the semiconductor while grinding it in a mill; synthesizing and precipitating the semiconductor fine particles in a reaction solvent; etc.

As a dispersion solvent, water or organic solvents such as methanol, ethanol, isopropyl alcohol, citronellol, terpineol, dichloromethane, acetone, acetonitrile, ethyl acetate, etc. may be used. A polymer such as polyethylene glycol, hydroxyethylcellulose and carboxymethylcellulose, a surfactant, an acid, a chelating agent, etc. may be used as a dispersing agent, if necessary. In particular, it is preferable that polyethylene glycol is added to the dispersion because the viscosity of the dispersion and the porosity of the semiconductor fine particle layer can be controlled and the semiconductor fine particle layer hardly peeled off can be formed by changing the molecular weight of the polyethylene glycol.

Preferred coating methods include: a roller method and a dip method as an application series; an air-knife method and a blade method as a metering series; etc. Further, preferable as a method where an application and metering can be carried out at the same portion are a wire-bar method disclosed in JP-B-58-4589, a slide-hopper method described in United States Patent Nos. 2,681,294, 2,761,419, 2,761,791, etc., an extrusion method, a curtain method, etc. Furthermore, as for a wide use, a spin method and a spray method are preferred. As a wet type printing method, three major printing methods of a relief printing, an offset printing and a gravure printing, an intaglio printing, a gum printing, a screen printing, etc. are preferred. A preferable film production method may be selected from these methods in accordance with the viscosity of the dispersion and the desired wet thickness.

The semiconductor fine particle layer is not limited to a single layer. The dispersions each comprising the semiconductor fine particles having a different particle size may be subjected to a multi-layer coating. Further, the dispersions each containing different kinds of semiconductor fine particles, binders or additives may be subjected to a multi-layer coating. The multi-layer coating is also effectively used when the thickness of the layer is insufficient by coating of once.

Generally, when the thickness of the semiconductor fine particle layer, equal to the thickness of the photosensitive layer, becomes thicker, the amount of the dye incorporated therein per unit projected area increases to make the light-capturing rate higher. However, because diffusion distances of the generated electrons are increased in this case, loss owing to recombination of the electric charges is also increased. Consequently, the preferable thickness of the semiconductor fine particle layer is 0.1 to 100 μm. In the photoelectric cell, the thickness of the semiconductor fine particle layer is preferably 1 to 30 μm, more preferably 2 to 25 μm. An applying amount of the semiconductor fine particles per 1 $m^2$ of the substrate is preferably 0.5 to 100 g, more preferably 3 to 50 g.

After applying the semiconductor fine particles onto the conductive support, the particles are preferably subjected to a heat treatment, thereby electronically contacting them with each other and increasing the coating strength and the adherence thereof with the support. The heating temperature is preferably 40 to 700 °C, more preferably 100 to 600 °C. The heating time is preferably 10 minutes to 10 hours. It is not preferred that the substrate having low melting point or softening point such as a polymer film substrate is subjected to a high temperature treatment because such

a substrate tends to be deteriorated thereby. The heat treatment is preferably carried out at a temperature as low as possible, for example, 50 to 350 °C, also from the viewpoint of cost. The semiconductor fine particle layer containing the smaller semiconductor fine particles having a size of 5 nm or less, a mineral acid, a metal oxide precursor, etc. can be heat-treated at such a low temperature. Further, the heat treatment may be carried out while applying ultraviolet ray, infrared ray, microwave, electric field, ultrasonic wave, etc. to the semiconductor fine particles, to reduce the heating temperature. To remove unnecessary organic compounds, etc., the heat treatment is preferably carried out in combination with evacuation, oxygen plasma treatment, washing by pure water, a solvent or a gas, etc.

After the heat treatment, the semiconductor fine particle layer may be subjected to a chemical metal-plating using an titanium tetrachloride aqueous solution, etc. or an electrochemical metal-plating using an titanium trichloride aqueous solution, etc., to increase the surface area of the semiconductor fine particles, or to enhance a purity of the particles, thereby improving the electron-injecting efficiency into the particles from the dye. Further, to prevent a reverse current from the semiconductor fine particles to the charge transfer layer, on the semiconductor fine particles is preferably adsorbed an organic compound having low electron conductivity other than the dye. The organic compound preferably has a hydrophobic group.

It is preferable that the semiconductor fine particle layer has a large surface area to adsorb many dyes. The surface area of the semiconductor fine particle layer is preferably 10 times or more, more preferably 100 times or more of its projected area. The highest limit, even though it is not limited in particular, is generally a level of 1000 times.

(3) Dye

In the present invention, the metal complex dye represented by the general formula (I) is used for the photosensitive layer. The metal complex dye of the general formula (I) may be used in combination with a known dye such as a ruthenium complex dye, an organic dye, etc.

(4) Adsorption of Dye to Semiconductor Fine Particle

The dye may be adsorbed to the semiconductor fine particles by soaking the conductive support having the well-dried semiconductor fine particle layer in a dye adsorption solution, or by applying the dye adsorption solution to the semiconductor fine particle layer. In the former case, a soaking method, a dipping method, a roller method, an air-knife method, etc. may be used. In the soaking method, the dye may be adsorbed at a room temperature, or under reflux while heating as described in Japanese Patent Laid-Open No. 7-249790. As an applying method of the latter case, a wire-bar method, a slide-hopper method, an extrusion method, a curtain method, a spin method, a spray method, etc. may be used. Further, the dye may be applied to the semiconductor fine particle layer by an ink-jet method, etc. into an image, thereby providing a photoelectric conversion surface having a shape of the image.

Preferred examples of a solvent for the dye adsorption solution include: alcohols such as methanol, ethanol, t-butanol and benzyl alcohol; nitrile compounds such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N,N*-dimethylformamide and *N,N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof.

The total amount of the dye is preferably 0.01 to 100 mmol per the unit surface area (1 $m^2$) of the conductive support. The amount of the dye adsorbed on the semiconductor fine particles is preferably 0.01 to 1 mmol per 1 g of the semiconductor fine particles. Such an adsorption amount of the dye effects a sufficient sensitization to the semiconductors. Too small amount of the dye results in insufficient sensitization effect. On the other hand, if the amount of the dye is excessive, the dye unadsorbed on the semiconductor fine particles floats to reduce the sensitization effect. To increase the adsorption amount of the dye, it is preferable that the semiconductor fine particle layer is subjected to a heat treatment before the dye is adsorbed thereon. After the heat treatment, it is preferable that the dye is quickly adsorbed on the semiconductor fine particle layer having a temperature of 60 to 150 °C before the layer is cooled to the room temperature, to prevent water from adsorbing onto the semiconductor fine particle layer.

To weaken an interaction between the dyes such as association, a colorless compound may be co-adsorbed onto the semiconductor fine particles together with the dye. The colorless compound preferably has surface activity, and examples thereof include steroid compounds having a carboxyl group such as chenodeoxycholic acid, and sulfonates shown below.

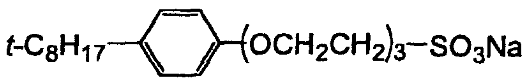

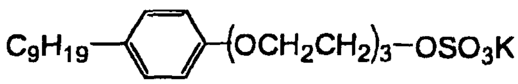

The dye unadsorbed on the semiconductor fine particle layer is preferably removed by washing immediately after the dye adsorption process. The washing is preferably carried out by a wet-type washing bath with a polar solvent such as acetonitrile or an organic solvent such as an alcohol solvent. The surface of the semiconductor fine particles may be treated with an amine compound or a quaternary salt after the dye adsorption process to remove excessive metal complex dye. The amine compound is preferably pyridine, 4-t-butylpyridine, polyvinylpyridine, etc., and the quaternary salt is preferably tetrabutylammonium iodide, tetrahexylammonium iodide, etc. The amine compound or the quaternary salt may be used singly if it is liquid, and may be used in a fashion of a solution in an organic solvent.

(C) Charge Transfer Layer

The charge transfer layer replenishes electrons to the oxidized dye. The charge transfer layer may be composed of (i) an ion conductive electrolyte composition or (ii) a carrier-mediated, charge-transporting material utilizing charge transport mediated by a carrier in solid. Examples of (i) the ion conductive electrolyte composition include: molten salt electrolyte compositions containing a redox couple; electrolysis solutions where a redox couple is dissolved in a solvent; so-called gel electrolyte compositions where a solution including a redox couple is penetrated into a polymer matrix; solid electrolyte compositions; etc. Examples of (ii) the carrier-mediated, charge-transporting material include electron-transporting materials and hole-transporting materials. These materials may be used in combination with each other.

(1) Molten Salt Electrolyte Composition

The molten salt electrolyte compositions are preferably used for the charge transfer layer from the viewpoint of improving the durability and the photoelectric conversion efficiency of the photoelectric conversion device. The molten salt electrolyte composition comprises a molten salt electrolyte having a low melting point. In the present invention, pyridinium salts, imidazolium salts, triazolium salts, etc. disclosed in WO 95/18456, Japanese Patent Laid-Open No. 8-259543, "Denki Kagaku (Electrochemistry)", 65, 11, 923 (1997), etc. may be used as the molten salt electrolyte. The molten salt electrolyte preferably has the melting point of 100 °C or less, and it is particularly preferably in a liquid state at the room temperature.

The molten salt electrolytes represented by any of the following general formulae (Y-a), (Y-b) and (Y-c) are preferably used in the present invention.

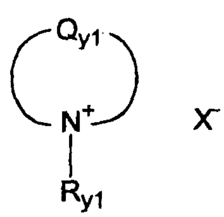

. . . (Y-a)

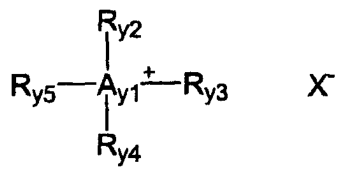

(Y-b)

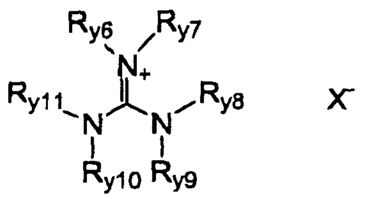

(Y-c)

In the general formula (Y-a), $Q_{y1}$ represents an atomic group forming an aromatic cation having a 5- or 6-membered ring structure with the nitrogen atom. $Q_{y1}$ is preferably composed of atoms selected from the group consisting of carbon, hydrogen, nitrogen, oxygen and sulfur atoms. The 5-membered ring formed by $Q_{y1}$ is preferably an oxazole ring, a thiazole ring, an imidazole ring, a pyrazole ring, an iso-oxazole ring, a thiadiazole ring, an oxadiazole ring, a triazole ring, an indole ring or a pyrrole ring, more preferably an oxazole ring, a thiazole ring or an imidazole ring, particularly preferably an oxazole ring or an imidazole ring. The 6-membered ring formed by $Q_{y1}$ is preferably a pyridine ring, a pyrimidine ring, a pyridazine ring, a pyrazine ring or a triazine ring, more preferably a pyridine ring.

In the general formula (Y-b), $A_{y1}$ represents a nitrogen atom or a phosphorus atom.

$R_{y1}$ to $R_{y11}$ in the general formulae (Y-a), (Y-b) and (Y-c) independently represent: a substituted or unsubstituted alkyl group preferably having 1 to 24 carbon atom, which may be straight, branched or cyclic, such as a methyl group, an ethyl group, a propyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, a cyclopentyl group, etc.; or a substituted or unsubstituted alkenyl group preferably having 2 to 24 carbon atoms, which may be straight or branched, such as a vinyl group, an allyl group, etc. $R_{y1}$ to $R_{y11}$ is more preferably an alkyl group having 2 to 18 carbon atoms or an alkenyl group having 2 to 18 carbon atoms, particularly preferably an alkyl group having 2 to 6 carbon atoms, respectively.

Two or more of $R_{y2}$ to $R_{y5}$ in the general formula (Y-b) may be bonded together to form a non-aromatic ring containing $A_{y1}$. Two or more of $R_{y6}$ to $R_{y11}$ in the general formula (Y-c) may be bonded together to form a ring.

$Q_{y1}$ and $R_{y1}$ to $R_{y11}$ in the general formulae (Y-a), (Y-b) and (Y-c) may have a substituent, respectively. Preferable examples of the substituent include: halogen atoms such as F, Cl, Br and I; cyano group; alkoxy groups such as a methoxy group, an ethoxy group, a methoxyethoxy group and a methoxyethoxyethoxy group; aryloxy groups such as a phenoxy group; alkylthio groups such as a methylthio group and an ethylthio group; alkoxycarbonyl groups such as an ethoxycarbonyl group; carbonate groups such as an ethoxycarbonyloxy group; acyl groups such as an acetyl group, a propionyl group and a benzoyl group; sulfonyl groups such as a methanesulfonyl group and a benzenesulfonyl group; acyloxy groups such as an acetoxy group and a benzoyloxy group; sulfonyloxy groups such as a methanesulfonyloxy group and a toluenesulfonyloxy group; phosphonyl groups such as a diethylphosphonyl group; amido groups such as an acetylamino group and a benzoylamino group; carbamoyl groups such as an *N*,*N*-dimethylcarbamoyl group; alkyl groups such as a methyl group, an ethyl group, a propyl group, an isopropyl group, a cyclopropyl group, a butyl group, a 2-carboxyethyl group and a benzyl group; aryl groups such as a phenyl group and a toluyl group; heterocyclic groups such as a pyridyl group, an imidazolyl group and a furanyl group; alkenyl groups such as a vinyl group and a 1-propenyl group; silyl groups; silyloxy groups; etc.

The molten salt electrolytes represented by the general formula (Y-a), (Y-b) or (Y-c) may form an oligomer or a polymer through any one of $Q_{y1}$ and $R_{y1}$ to $R_{y11}$.

In the general formulae (Y-a), (Y-b) and (Y-c), $X^-$ represents an anion. Preferred examples of the anion include: halide ions such as $I^-$, $Cl^-$ and $Br^-$, $SCN^-$, $BF_4^-$, $PF_6^-$, $ClO_4^-$, $N^-(SO_2CF_3)_2$, $N^-(SO_2CF_2CF_3)_2$, $CH_3SO_3^-$, $CF_3SO_3^-$, $CF_3COO^-$, $BPh_4^-$, $C^-(SO_2CF_3)_3$, etc. $X^-$ is more preferably $SCN^-$, $BF_4^-$, $N^-(SO_2CF_3)_2$, $CF_3SO_3^-$ or $CF_3COO^-$.

Examples of the molten salt electrolytes preferably used in the present invention will be illustrated below without intention of restricting the scope of the present invention defined by the claims attached hereto.

Y1

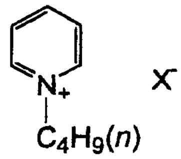

Y1-1: $X^-$=$I^-$
Y1-2: $X^-$=$BF_4^-$
Y1-3: $X^-$=$N^-(SO_2CF_3)_2$
Y1-4: $X^-$=$PF_6^-$

Y2

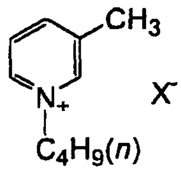

Y2-1: $X^-$=$I^-$
Y2-2: $X^-$=$BF_4^-$
Y2-3: $X^-$=$N^-(SO_2CF_3)_2$
Y2-4: $X^-$=$CF_3COO^-$
Y2-5: $X^-$=$SCN^-$
Y2-6: $X^-$=$CF_3SO_3^-$

Y3

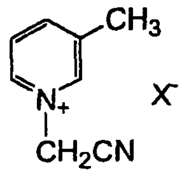

Y3-1: $X^-$=$I^-$
Y3-2: $X^-$=$BF_4^-$
Y3-3: $X^-$=$N^-(SO_2CF_3)_2$

Y4

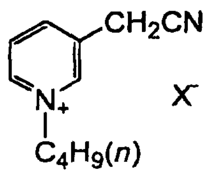

Y4-1: $X^-$=$I^-$
Y4-2: $X^-$=$BF_4^-$
Y4-3: $X^-$=$N^-(SO_2CF_3)_2$

Y5

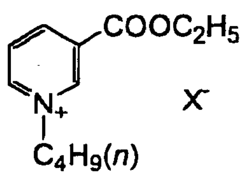

Y5-1: $X^-$=$I^-$
Y5-2: $X^-$=$BF_4^-$
Y5-3: $X^-$=$N^-(SO_2CF_3)_2$

Y6

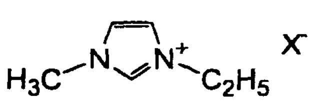

Y6-1: $X^-$=$I^-$
Y6-2: $X^-$=$BF_4^-$
Y6-3: $X^-$=$N^-(SO_2CF_3)_2$
Y6-2: $X^-$=$Br^-$
Y6-5: $X^-$=$CF_3COO^-$
Y6-6: $X^-$=$SCN^-$
Y6-7: $X^-$=$CF_3SO_3^-$

Y7

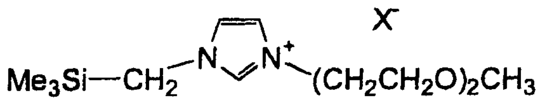

Y7-1: $X^-=I^-$
Y7-2: $X^-=BF_4^-$
Y7-3: $X^-=N^-(SO_2CF_3)_2$
Y7-4: $X^-=CF_3COO^-$
Y7-5: $X^-=SCN^-$

Y8

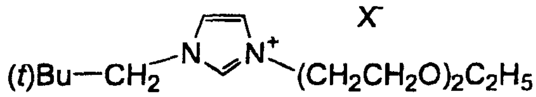

Y8-1: $X^-=I^-$
Y8-2: $X^-=BF_4^-$
Y8-3: $X^-=N^-(SO_2CF_3)_2$
Y8-4: $X^-=PF_6^-$
Y8-5: $X^-=CF_3COO^-$
Y8-6: $X^-=SCN^-$
Y8-7: $X^-=CF_3SO_3^-$

Y9

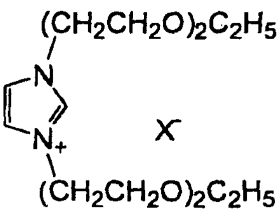

Y9-1: $X^-=I^-$
Y9-2: $X^-=BF_4^-$
Y9-3: $X^-=N^-(SO_2CF_3)_2$
Y9-4: $X^-=CF_3COO^-$
Y9-5: $X^-=SCN^-$
Y9-6: $X^-=CF_3SO_3^-$

Y10

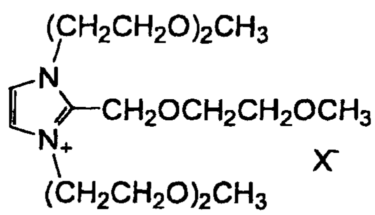

Y10-1: $X^-=I^-$
Y10-2: $X^-=BF_4^-$
Y10-3: $X^-=N^-(SO_2CF_3)_2$

Y11

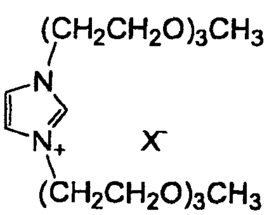

Y11-1: $X^-=I^-$
Y11-2: $X^-=BF_4^-$
Y11-3: $X^-=N^-(SO_2CF_3)_2$

Y12 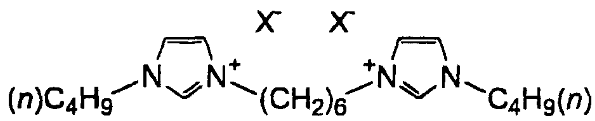

Y12-1: $X^-=I^-$
Y12-2: $X^-=BF_4^-$
Y12-3: $X^-=N^-(SO_2CF_3)_2$

Y13 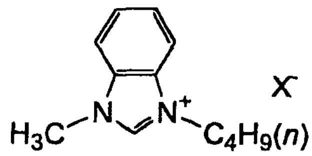

Y13-1: $X^-=I^-$
Y13-2: $X^-=BF_4^-$
Y13-3: $X^-=N^-(SO_2CF_3)_2$

Y14 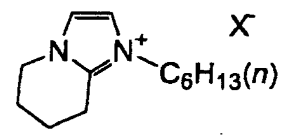

Y14-1: $X^-=I^-$
Y14-2: $X^-=BF_4^-$
Y14-3: $X^-=N^-(SO_2CF_3)_2$

Y15 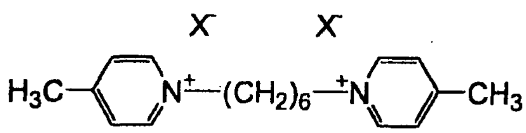

Y15-1: $X^-=I^-$
Y15-2: $X^-=BF_4^-$
Y15-3: $X^-=N^-(SO_2CF_3)_2$

Y16 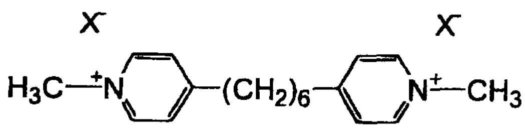

Y16-1: $X^-=I^-$
Y16-2: $X^-=BF_4^-$
Y16-3: $X^-=N^-(SO_2CF_3)_2$

Y17

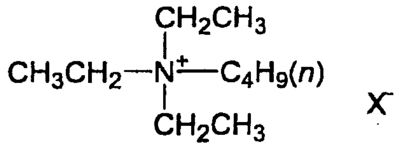

Y17-1: $X^-=I^-$
Y17-2: $X^-=BF_4^-$
Y17-3: $X^-=N^-(SO_2CF_3)_2$
Y17-4: $X^-=PF_6^-$

Y18

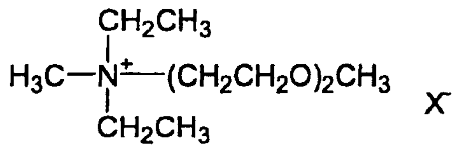

Y18-1: $X^-=I^-$
Y18-2: $X^-=BF_4^-$
Y18-3: $X^-=N^-(SO_2CF_3)_2$

Y19

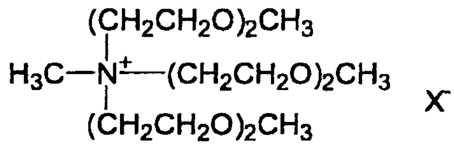

Y19-1: $X^-=I^-$
Y19-2: $X^-=BF_4^-$
Y19-3: $X^-=N^-(SO_2CF_3)_2$
Y19-4: $X^-=CF_3COO^-$
Y19-5: $X^-=SCN^-$
Y19-6: $X^-=CF_3SO_3^-$

Y20

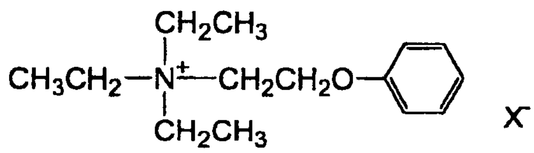

Y20-1: $X^-=I^-$
Y20-2: $X^-=BF_4^-$
Y20-3: $X^-=N^-(SO_2CF_3)_2$

Y21

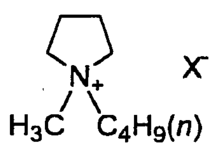

Y21-1: $X^-=I^-$
Y21-2: $X^-=BF_4^-$
Y21-3: $X^-=N^-(SO_2CF_3)_2$

Y22

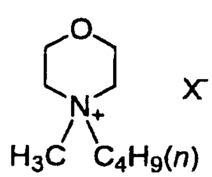

Y22-1: $X^-=I^-$
Y22-2: $X^-=BF_4^-$
Y22-3: $X^-=N^-(SO_2CF_3)_2$

Y23 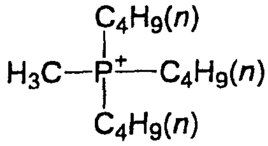 $X^-$

Y23-1: $X^-=I^-$
Y23-2: $X^-=BF_4^-$
Y23-3: $X^-=N^-(SO_2CF_3)_2$

Y24 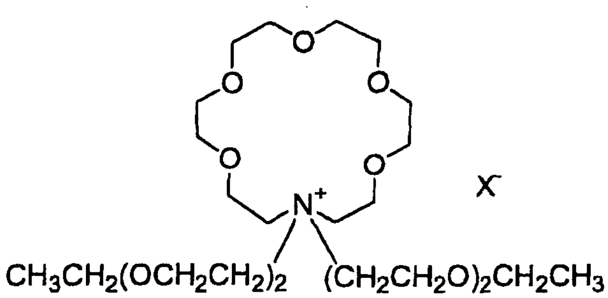 $X^-$

Y24-1: $X^-=I^-$
Y24-2: $X^-=BF_4^-$
Y24-3: $X^-=N^-(SO_2CF_3)_2$

Y25 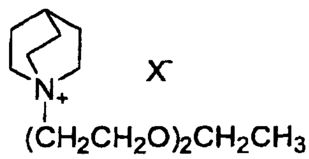 $X^-$

Y25-1: $X^-=I^-$
Y25-2: $X^-=BF_4^-$
Y25-3: $X^-=N^-(SO_2CF_3)_2$

Y26 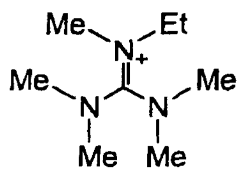 $X^-$

Y26-1: $X^-=I^-$
Y26-2: $X^-=N^-(SO_2CF_3)_2$
Y26-3: $X^-=BF_4^-$
Y26-4: $X^-=PF_6^-$

Y27 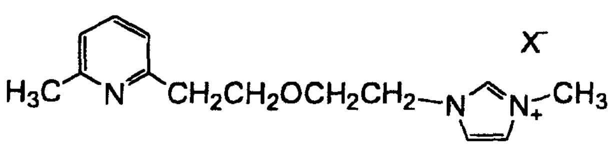 $X^-$

Y27-1: $X^-=I^-$
Y27-2: $X^-=N^-(SO_2CF_3)_2$
Y27-3: $X^-=BF_4^-$
Y27-4: $X^-=CF_3COO^-$
Y27-5: $X^-=SCN^-$
Y27-6: $X^-=CF_3SO_3^-$

Y28

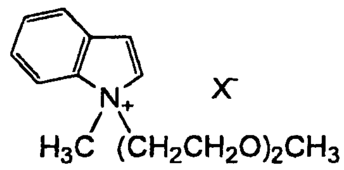

Y29

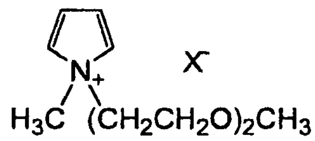

The molten salt electrolytes may be used singly or in combination with each other. In addition, the molten salt electrolyte may be used in combination with another iodine salt such as LiI or an alkali metal salt such as $CF_3COOLi$, $CF_3COONa$, LiSCN and NaSCN. Weight ratio of the alkali metal salt is preferably 0.02 to 2 weight %, more preferably 0.1 to 1 weight %, to 100 weight % of the molten salt electrolyte composition.

Though the molten salt electrolyte composition may comprise a solvent described below, it particularly preferably comprises no solvent. The content of the molten salt electrolyte is preferably 50 weight % or more, particularly preferably 90 weight % or more, based on the entire composition. The weight ratio of the iodine salts contained in the molten salt electrolyte composition is preferably 50 weight % or more to the entire salts contained therein.

The molten salt electrolyte composition preferably comprises iodine. The iodine-content is preferably 0.1 to 20 weight %, more preferably 0.5 to 5 weight % based on the entire composition.

(2) Electrolysis Solution

The electrolysis solution used in the present invention is preferably composed of an electrolyte, a solvent and an additive. The electrolyte may be: a combination of $I_2$ and an iodide (a metal iodide such as LiI, NaI, KI, CsI and $CaI_2$, a quaternary ammonium iodide such as a tetralkylammonium iodide, pyridinium iodide and imidazolium iodide, etc.); a combination of $Br_2$ and a bromide (a metal bromide such as LiBr, NaBr, KBr, CsBr and $CaBr_2$, a quaternary ammonium bromide such as a tetralkylammonium bromide and pyridinium bromide, etc.); a metal complex such as a ferrocyanide-ferricyanide and a ferrocene-ferricinium ion; a sulfur compound such as sodium polysulfide and an alkylthiol-alkyldisulfide; a viologen dye; hydroquinone-quinone; etc. Among them, preferred is a combination of $I_2$ and LiI or the quaternary ammonium iodide. A plurality of the electrolytes may be mixed to be in use.

The concentration of the electrolyte in the electrolysis solution is preferably 0.1 to 10 M, more preferably 0.2 to 4 M. Further, the electrolysis solution may comprise iodine, and the concentration of iodine therein is preferably 0.01 to 0.5 M.

The solvent used for the electrolysis solution is preferably such that has a low viscosity and a high ionic mobility or has a high permittivity and can increase the actual carrier concentration of the electrolysis solution, to exhibit an excellent ionic conductibility. Examples of the solvent include: carbonates such as ethylene carbonate and propylene carbonate; heterocyclic compounds such as 3-methyl-2-oxazolidinone; ethers such as dioxan and diethyl ether; chain ethers such as ethyleneglycol dialkylethers, propyleneglycol dialkylethers, polyethyleneglycol dialkylethers and polypropyleneglycol dialkylethers; alcohols such as methanol, ethanol, ethyleneglycol monoalkylethers, propyleneglycol monoalkylethers, polyethyleneglycol monoalkylethers and polypropyleneglycol monoalkylethers; glycols such as ethylene glycol, propylene glycol, polyethylene glycol, polypropylene glycol and glycerin; nitrile compounds such as acetonitrile, glutarodinitrile, methoxyacetonitrile, propionitrile and benzonitrile; aprotic polar solvents such as dimethylsulfoxide (DMSO) and sulfolane; water; etc. These solvents may be used in combination with each other.

To the above-mentioned molten salt electrolyte composition and the electrolysis solution is preferably added a basic compound such as t-butylpyridine, 2-picoline, 2,6-lutidine, etc., as described in J. Am. Ceram. Soc., 80 (12), 3157 to 3171 (1997). The concentration of the basic compound is preferably 0.05 to 2 M.

(3) Gel Electrolyte Composition

The molten salt electrolyte composition and the electrolysis solution mentioned above may be gelled or solidified to prepare the gel electrolyte composition. Gelation may be achieved by: adding a polymer; adding an oil-gelling

agent; polymerization of monomers including a multifunctional monomer; a cross-linking reaction of a polymer; etc.

In the case where the gel electrolyte composition is prepared by adding a polymer, compounds described in "Polymer Electrolyte Reviews 1 and 2", edited by J. R. MacCallum and C. A. Vincent, ELSEIVER APPLIED SCIENCE may be used as the polymer. Of the compounds, polyacrylonitrile and poly(vinylidene fluoride) are preferred.

In the case where the gel electrolyte composition is prepared by adding an oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. may be used as the oil-gelling agent. Of the compounds, preferred are those having an amide structure.

In the case where the gel electrolyte composition is prepared by a cross-linking reaction of a polymer, it is preferable that a polymer containing a group having cross-linking reactivity is used with a cross-linking agent. The group having the cross-linking reactivity is preferably an amino group or a nitrogen-containing heterocyclic group such as a pyridyl group, an imidazolyl group, a thiazolyl group, an oxazolyl group, a triazolyl group, a morpholyl group, a piperidyl group, a piperazyl group, etc. The cross-linking agent is preferably an electrophilic agent having a plurality of functional groups that may be attacked by the nitrogen atom, for example, multi-functional alkyl halides, aralkyl halides, sulfonates, acid anhydrides, acyl chlorides, isocyanates, α,β-unsaturated sulfonyl compounds, α,β-unsaturated carbonyl compounds, α,β-unsaturated nitrile compounds, etc. Cross-linking methods disclosed in Japanese Patent Laid-Open Nos. 2000-17076 and 2000-86724 may be used in the present invention.

Further, a method for gelling an electrolysis solution disclosed in Japanese Patent Laid-Open No. 11-185863 and a method for gelling a molten salt electrolyte composition disclosed in Japanese Patent Laid-Open No. 2000-58140 may be used in this invention.

(4) Hole-Transporting Material

In the present invention, an organic solid hole-transporting material, an inorganic solid hole-transporting material or a combination thereof may be used for the charge transfer layer instead of the ion conductive electrolyte composition such as the molten salt electrolyte composition.

(a) Organic Hole-Transporting Material

Preferred examples of the organic hole-transporting material used in this invention include: aromatic amines disclosed in J. Hagen, et al., Synthetic Metal, 89, 215 to 220 (1997), Nature, Vol. 395, 8 Oct. 1998, Page 583 to 585, WO 97/10617, United States Patent Nos. 4,923,774 and 4,764,625, Japanese Patent Laid-Open Nos. 59-194393, 5-234681, 4-308688, 3-269084, 4-129271, 4-175395, 4-264189, 4-290851, 4-364153, 5-25473, 5-239455, 5-320634, 6-1972, 7-138562, 7-252474 and 11-144773, etc.; triphenylenes disclosed in Japanese Patent Laid-Open Nos. 11-149821, 11-148067 and 11-176489, etc.; oligothiophene compounds disclosed in Adv. Mater., 9, No. 7, 557, 1997, Angew. Chem. Int. Ed. Engl., 34, 3, 303 to 307, 1995, J. Am. Chem. Soc., Vol. 120, No. 4, Page 664 to 672, 1998, etc.; and conductive polymers such as polypyrrole disclosed in K. Murakoshi, et al., Chem. Lett., 471, 1997 and polyacetylene, poly(*p*-phenylene), poly(*p*-phenylenevinylene), polythienylenevinylene, polythiophene, polyaniline, polytoluidine and derivatives thereof disclosed in "Handbook of Organic Conductive Molecules and Polymers", Vols. 1 to 4, edited by NALWA, published by WILEY.

As described in Nature, Vol. 395, 8 Oct. 583 to 585 (1998), to the organic hole-transporting material may be added a compound having cation radical such as tris(4-bromophenyl)aminium hexachloroantimonate to control the dopant level, or a salt such as $Li[(CF_3SO_2)_2N]$ to achieve potential-control of surface of the semiconductor, thereby compensating a space-charge layer.

(b) Inorganic Hole-Transporting Material

The inorganic hole-transporting material may be composed of a p-type inorganic compound semiconductor. Band gap of the p-type inorganic compound semiconductor is preferably 2 eV or more, more preferably 2.5 eV or more. Ionization potential of the p-type inorganic compound semiconductor should be smaller than that of the photosensitive layer to reduce holes of the dye. Although the ionization potential of the p-type inorganic compound semiconductor may be selected depending on the kind of the dye, generally, it is preferably 4.5 to 5.5 eV, more preferably 4.7 to 5.3 eV. The p-type inorganic compound semiconductor is preferably a compound semiconductor having a monovalent copper such as CuI, CuSCN, $CuInSe_2$, $Cu(In,Ga)Se_2$, $CuGaSe_2$, $Cu_2O$, CuS, $CuGaS_2$, $CuInS_2$, $CuAlSe_2$, etc. Among them, CuI and CuSCN are preferred, and CuI is the most preferred. GaP, NiO, CoO, FeO, $Bi_2O_3$, $MoO_2$, $Cr_2O_3$, etc. are also used as the p-type inorganic compound semiconductor.

(5) Method for Forming Charge Transfer Layer

The charge transfer layer may be provided by any of the following two methods. One is a method where the counter electrode is stuck on the photosensitive layer beforehand and the material for the charge transfer layer in the liquid state is made to penetrate a gap therebetween. Another is a method where the charge transfer layer is directly provided on the photosensitive layer, the counter electrode being then formed thereon.
In the former method, the material for the charge transfer layer may be made to penetrate the gap by a normal pressure process utilizing capillarity, or by a reduced pressure process where the material is pumped up through the gap to replace gas phase therein with liquid phase.
In the case of providing a wet charge transfer layer by the latter method, the wet charge transfer layer is applied to the photosensitive layer, the counter electrode is disposed on the wet charge transfer layer without drying it, and edges thereof is subjected to a treatment for preventing liquid-leakage, if necessary. In the case of providing a gel charge transfer layer by the latter method, the charge transfer material may be applied in the liquid state and gelled by polymerization, etc. In this case, the counter electrode may be disposed on the charge transfer layer before or after drying and fixing the charge transfer layer.
Also, the charge transfer layer composed of the electrolysis solution, the wet organic hole-transporting material, the gel electrolyte composition, etc. may be disposed by a roller method, a dip method, an air-knife method, an extrusion method, a slide-hopper method, a wire-bar method, a spin method, a spray method, a cast method, various printing methods, etc. similarly to the case of forming the semiconductor fine particle layer, or adsorbing a dye to the semiconductor mentioned above.
The charge transfer layer composed of the solid electrolyte, the solid hole transporting material, etc. may be formed by a dry film-forming method such as a vacuum deposition method and a CVD method, and followed by disposing the counter electrode thereon. The organic hole-transporting material may be made to penetrate into the photosensitive layer by a vacuum deposition method, a cast method, a coating method, a spin-coating method, a soaking method, an electrolytic polymerization method, a photo-polymerization method, etc. The inorganic hole-transporting material may be made to penetrate into the photosensitive layer by a cast method, a coating method, a spin-coating method, a soaking method, an electrolytic deposition method, an electroless deposition method, etc.

(D) Counter Electrode

The counter electrode is the counter electrically conductive layer, which is supported by the substrate, if necessary. Examples of the electrically conductive material used for the counter electrically conductive layer include: metals such as platinum, gold, silver, copper, aluminum, magnesium and indium; carbon; and electrically conductive metal oxides such as indium-tin composite oxides and fluorine-doped tin oxides. Among them, preferred are platinum, gold, silver, copper, aluminum and magnesium. The substrate of the counter electrode is preferably made of a glass or a plastic to be coated or vapor-deposited with the electrically conductive material. The counter electrically conductive layer preferably has a thickness of 3 nm to 10 μm, although the thickness is not particularly limited. The surface resistance of the counter electrically conductive layer is desirably as low as possible. The surface resistance is preferably 50 Ω/square or less, more preferably 20 Ω/square or less.
Light may be irradiated from any one or both side of the conductive support and the counter electrode, so that at least one of them should be substantially transparent to have light reached to the photosensitive layer. From a viewpoint of improving electric generation efficiency, it is preferable that the conductive support is substantially transparent to irradiate light therethrough. In this case, the counter electrode preferably has a light-reflective property. Such a counter electrode may be composed of a glass or a plastic having a vapor-deposited layer of a metal or an electrically conductive oxide, or a metal thin film.
The counter electrode may be disposed by applying, metal-plating or vapor-depositing (PVD, CVD, etc.) the electrically conductive material directly onto the charge transfer layer, or by putting the electrically conductive layer formed on the substratre onto the charge transfer layer. It is preferable that the metal lead is used to reduce the resistance of the counter electrode, as similar to the conductive support. The metal lead is particularly preferably used for the transparent counter electrode. Preferable embodiments of the metal lead used for the counter electrode are the same as those of the metal lead used for the conductive support mentioned above.

(E) Others

It is preferable that a fine semiconductor thin film is provided between the conductive support and the photosensitive layer as an undercoating layer to prevent short-circuit of the counter electrode and the conductive support, particularly in the case of the charge transfer layer composed of the electron-transporting material or the hole-transporting material. The undercoating layer is preferably made of $TiO_2$, $SnO_2$, $Fe_2O_3$, $WO_3$, ZnO or $Nb_2O_5$, more preferably

made of $TiO_2$. The undercoating layer may be disposed by a spray-pyrolysis method described in Electrochim. Acta, 40, 643 to 652 (1995), a sputtering method, etc. The thickness of the undercoating layer is preferably 5 to 1000 nm, more preferably 10 to 500 nm.

Functional layers such as a protective layer and a reflection-preventing layer may be disposed on any one or both of the conductive support and the counter electrode. The functional layers may be disposed between the electrically conductive layer and the substrate, or in the substrate. The functional layers may be disposed by a method selected in accordance with the materials therefor, such as a coating method, a vapor-deposition method and a sticking method.

(F) Interior Structure of Photoelectric Conversion Device

As described above, the photoelectric conversion device may have various interior structures in accordance with an end of use. The structures are classified into two major forms, a structure allowing light incidence from both faces, and a structure allowing it from only one face. Each of Figs. 2 to 9 illustrates an example of the interior structure of the photoelectric conversion device, which is preferable in the present invention.

In the structure illustrated in Fig. 2, the photosensitive layer 20 and the charge transfer layer 30 are disposed between the transparent electrically conductive layer 10a and the transparent counter electrically conductive layer 40a. This structure allows light incidence from both faces of the device.

In the structure illustrated in Fig. 3, on the transparent substrate 50a partially having the metal lead 11 is disposed the transparent electrically conductive layer 10a, the undercoating layer 60, the photosensitive layer 20, the charge transfer layer 30 and the counter electrically conductive layer 40 are laminated in this order, and the substrate 50 is further placed thereon. This structure allows light incidence from the electrically conductive layer side.

In the structure illustrated in Fig. 4, the photosensitive layer 20 is disposed on the substrate 50 having the electrically conductive layer 10 through the undercoating layer 60, the charge transfer layer 30 and the transparent counter electrically conductive layer 40a are disposed thereon, and further the transparent substrate 50a locally having the metal lead 11 is placed on the counter electrically conductive layer 40a so that the metal lead 11 side orients inward. This structure allows light incidence from the counter electrode side.

In the structure illustrated in Fig. 5, on the two transparent substrates 50a each having the metal lead 11 partially are formed the transparent electrically conductive layer 10a and the transparent counter electrically conductive layer 40a, respectively, and the undercoating layer 60, the photosensitive layer 20 and the charge transfer layer 30 placed between the conductive layers. This structure allows light incidence from both faces of the photoelectric conversion device.

In the structure illustrated in Fig. 6, on the transparent substrate 50a having the transparent electrically conductive layer 10a is disposed the photosensitive layer 20 through the undercoating layer 60, the charge transfer layer 30 and the counter electrically conductive layer 40 are formed thereon, and further the substrate 50 is placed on the counter electrically conductive layer 40. This structure allows light incidence from the electrically conductive layer side.

In the structure illustrated in Fig. 7, on the substrate 50 having the electrically conductive layer 10 is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from the counter electrode side.

In the structure illustrated in Fig. 8, on the transparent substrate 50a having the transparent electrically conductive layer 10a is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from both faces of the photoelectric conversion device.

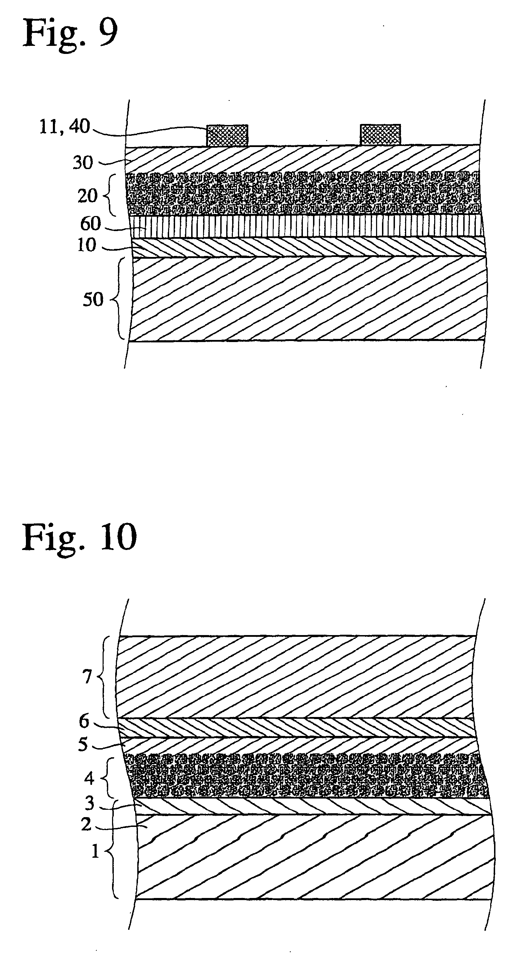

In the structure illustrated in Fig. 9, the photosensitive layer 20 is disposed on the substrate 50 having the electrically conductive layer 10 through the undercoating layer 60, the solid charge transfer layer 30 is disposed thereon, and further the counter electrically conductive layer 40 or the metal lead 11 is locally placed on the solid charge transfer layer 30. This structure allows light incidence from the counter electrode side.

[3] Photoelectric Cell

The photoelectric cell of the present invention is constituted by connecting the photoelectric conversion device of the present invention to an external circuit to electrically work or generate electricity in the external circuit. Such a photoelectric cell that has the charge transfer layer composed of the ion conductive electrolyte composition is generally referred to as a photo-electrochemical cell. A photoelectric cell intended for power generation utilizing solar light is generally referred to as a solar cell.

The side face of the photoelectric cell is preferably sealed with a polymer or an adhesive agent, etc. to prevent

deterioration and volatility of the content in the cell. The external circuit is connected to the conductive support and the counter electrode via a lead. Various known circuits may be used in the present invention.

In the case where the photoelectric conversion device of the present invention is used for the solar cell, the interior structure of the solar cell may be essentially the same as that of the photoelectric conversion device mentioned above. The solar cell comprising the photoelectric conversion device of the present invention may have a known module structure. In general module structure of the solar cell, cells are placed on a substrate of metal, ceramic, etc. and covered with a packing resin, a protective glass, etc., whereby light is introduced from the opposite side of the substrate. The solar cell module may have a structure where the cells are placed on a substrate of a transparent material such as a tempered glass to introduce light from the transparent substrate side. Specifically, a superstraight type module structure, a substrate type module structure, a potting type module structure, substrate-integrated type module structure that is generally used in amorphous silicon solar cells, etc. are known as the solar cell module structure. The solar cell comprising the photoelectric conversion device of the present invention may have a module structure properly selected from the above structures in accordance with ends and environment at use, and preferably has a module structure disclosed in Japanese Patent Laid-Open No. 2000-268892.

EXAMPLES

The present invention will be explained in more detail with reference to examples below without intention of restricting the scope of the present invention.

1. Synthesis of Ligand L1-1 and Preparation of Metal Complex Dye D-1

The ligand L1-1 was synthesized and the metal complex dye D-1 was prepared from the ligand L1-1 as follows.

(1) Synthesis of Ligand L1-1

3.7 g of potassium permanganate was dissolved in a mixed solvent of water (50 ml) / acetone (25 ml), and to this was added 0.5 g of 4,4',5,5'-tetramethyl-2,2'-bipyridine. The resulting solution was stirred at 80 °C for 3 days, and then, subjected to thermal time filtration. Concentrated hydrochloric acid was added to the resultant mixture to convert the mixture into an acidic state, so that 0.20 g of a hydrochloride of the ligand L1-1 was separated by filtration. Structure of the product was identified by NMR and MS spectra.

(2) Preparation of Metal Complex Dye D-1

0.2 g of thus-obtained hydrochloride of the ligand L1-1 and 0.06 g of ruthenium chloride were dissolved in 20 ml of dimethylformamide, and to this was added 0.17 ml of triethylamine. The resulting mixture was heated under nitrogen at 120 °C for 4 hours. Then, 0.22 g of ammonium thiocyanate was added to the resultant and further heated at 120 °C for 4 hours. The mixture was cooled and concentrated, and the residue was purified by "Sephadex Column LH-20" (developing solvent: methanol) followed by neutralization, to obtain 0.10 g of the metal complex dye D-1 as crystal. Structure of the product was identified by NMR and MS spectra. Thus-obtained metal complex dye D-1 exhibited an absorption maximum in visible wavelength region at 576 nm in MeOH.

2. Preparation of Titanium Dioxide Dispersion

15 g of titanium dioxide "Degussa P-25" manufactured by Nippon Aerosil K.K., 45 g of water, 1 g of dispersant "Triton X-100" manufactured by Aldrich and 30 g of zirconia beads having a diameter of 0.5 mm manufactured by Nikkato K.K. were charged in a stainless steel vessel coated with Teflon inside having an inner volume of 200 ml, and subjected to a dispersion treatment for 2 hours at 1,500 rpm by means of a sand-grinder mill manufactured by Imex K.K. After the dispersion treatment, the zirconia beads were removed by filtration to obtain a titanium dioxide dispersion. The titanium dioxide fine particles in thus-obtained dispersion had an average particle diameter of 2.5 μm, the particle diameter being measured by Master Sizer manufactured by MALVERN.

3. Preparation of Dye-Sensitized $TiO_2$ Electrode

The above titanium dioxide dispersion was applied to an electrically conductive surface of a conductive glass having a fluorine-doped tin oxide coating by a glass bar. Used as the conductive glass was "TCO Glass-U" manufactured by Asahi Glass K.K. having a surface resistance of approximately 30 Ω/square, which was cut into 20 mm x 20 mm in size beforehand, and the amount of the applied titanium dioxide (semiconductor fine particle) was 20 g/$m^2$. Herein, an

adhesive tape was attached to the electrically conductive surface of the conductive glass at portions of from the edge to 3 mm as a spacer, eight conductive glasses were arranged such that the adhesive tapes come to both edges thereof, and to the eight conductive glasses were applied the titanium dioxide dispersion at once. The titanium dioxide dispersion-applied conductive glass was air-dried for one day at a room temperature after peeling the adhesive tape.

Then, the conductive glass was placed in an electric furnace "muffle furnace FP-32" manufactured by Yamato Science K.K., followed by burning at 450 °C for 30 minutes to obtain a $TiO_2$ electrode. After the $TiO_2$ electrode was taken out of the electric furnace and cooled, it was immersed in a methanol solution comprising the metal complex dye D-1 for 15 hours so that the dye was adsorbed on the titanium dioxide, further immersed in 4-t-butylpyridine for 15 minutes, washed with ethanol and air-dried to obtain a dye-sensitized $TiO_2$ electrode. The concentration of the metal complex dye D-1 in the methanol solution was $3 \times 10^{-4}$ mol/l, and the thickness of thus-obtained photosensitive layer was 10 μm.

4. Production of Photoelectric Conversion Device

The 20 mm x 20 mm in size of the dye-sensitized $TiO_2$ electrode prepared as described above was put on a platinum-deposited glass having the same size. Then, an electrolysis solution of 3-methoxypropionitrile comprising 0.65 mol/l of 1-methyl-3-hexylimidazolium iodide and 0.05 mol/l of iodine was permeated into a crevice between the glasses through capillarity and introduced into the dye-sensitized $TiO_2$ electrode, to obtain a photoelectric conversion device *1* of the present invention. According to this example, a photoelectric conversion device having a structure shown in Fig. 10, in which a conductive glass 1 composed of a glass 2 and an electrically conductive layer 3, a dye-sensitized $TiO_2$ layer 4, an electrolyte layer 5, a platinum layer 6 and a glass 7 were laminated in this order, was produced.

Photoelectric conversion devices *2* to *10* of the present invention and a comparative photoelectric conversion device *11* were produced in the same manner as the photoelectric conversion device *1* except that the dyes shown in Table 1 were used instead of the metal complex dye D-1, respectively.

5. Measurement of Photoelectric Conversion Efficiency

A simulated sunlight was irradiated to each of the photoelectric conversion devices *1* to *11*, so that each photoelectric conversion device was measured with respect to the generated electricity by a current-voltage tester "Keithley SMU238" to obtain open circuit voltage (V). The results are shown in Table 1. Incidentally, the simulated sunlight was obtained by passing light of 500 W Xenone Lamp manufactured by Ushio K.K. through an "AM 1.5 filter" manufactured by Oriel Co. and a sharp cut filter "Kenko L-42". The simulated sunlight was free of ultraviolet rays and had intensity of 100 $mW/cm^2$.

Table 1

| Photoelectric Conversion Device | Dye | Open Circuit Voltage (V) |
|---|---|---|
| 1 | D-1 | 0.80 |
| 2 | D-2 | 0.78 |
| 3 | D-3 | 0.85 |
| 4 | D-4 | 0.81 |
| 5 | D-5 | 0.82 |
| 6 | D-6 | 0.79 |
| 7 | D-7 | 0.77 |
| 8 | D-8 | 0.80 |
| 9 | D-9 | 0.76 |
| 10 | D-10 | 0.84 |
| 11 | Comparative Dye 1 | 0.55 |

Comparative Dye 1

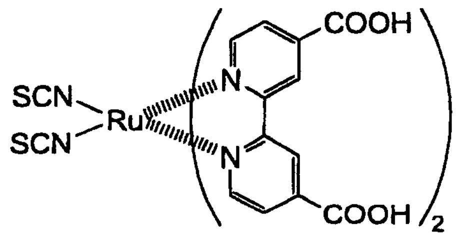

As shown in Table 1, each photoelectric conversion device *1* to *10* of the present invention comprising the metal complex dye represented by the general formula (I) was excellent in the open circuit voltage as compared with the comparative photoelectric conversion device *11* using the known Comparative Dye 1.

As described in detail above, the photoelectric conversion device and the photoelectric cell according to the present invention comprises a metal complex dye represented by the general formula (I) to exhibit a high open circuit voltage.

## Claims

**1.** A photoelectric conversion device comprising a semiconductor fine particle sensitized by a metal complex dye, wherein said metal complex dye is represented by the following general formula (I):

$$M(L1)_{m1}(L2)_{m2}(L3)_{m3} \cdot Cl \qquad (I)$$

wherein M is a metal atom;

L1 is a bidentate or tridentate ligand represented by the following general formula (II):

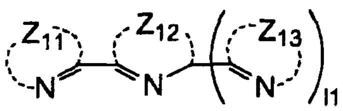

· · · (II)

wherein $Z_{11}$, $Z_{12}$ and $Z_{13}$ independently represent non-metallic atoms forming a 5- or 6-membered ring, said 5- or 6-membered ring optionally has a substituent and optionally forms a condensed ring in combination with another ring, at least one of $Z_{11}$ and $Z_{12}$ forms a pyridine ring or a condensed ring comprising a pyridine ring that has a plurality of acidic groups, and 11 represents 0 or 1;

L2 is a bidentate or tridentate ligand represented by the following general formula (III):

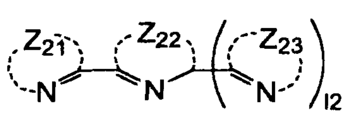

· · · (III)

wherein $Z_{21}$, $Z_{22}$ and $Z_{23}$ independently represent non-metallic atoms forming a 5- or 6-membered ring, said 5- or 6-membered ring optionally has a substituent and optionally forms a condensed ring in combination with another ring, and 12 represents 0 or 1;

L3 is a monodentate or bidentate ligand;

m1 is an integer of 1 to 3;
m2 is an integer of 0 to 2;
m3 is an integer of 0 to 4; and
CI is a counter ion optionally contained in said metal complex dye to neutralize charge thereof.

**2.** The photoelectric conversion device according to claim 1, wherein said m1 is 2 and said m2 is 0.

**3.** The photoelectric conversion device according to claim 1 or 2, wherein said plurality of acidic groups comprise a carboxyl group.

**4.** The photoelectric conversion device according to any one of claims 1 to 3, wherein said semiconductor fine particle is a titanium oxide fine particle.

**5.** A photoelectric cell comprising the photoelectric conversion device recited in any one of claims 1 to 4.

**6.** A ruthenium complex dye represented by the following general formula (IV):

$$Ru(L4)_{m1}(L2)_{m2}(L3)_{m3} \cdot CI \qquad (IV)$$

wherein L4 is a bidentate or tridentate ligand represented by the following general formula (V):

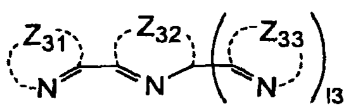

· · · (V)

wherein $Z_{31}$, $Z_{32}$ and $Z_{33}$ independently represent non-metallic atoms forming a 5- or 6-membered ring, said 5- or 6-membered ring optionally has a substituent and optionally forms a condensed ring in combination with another ring, at least one of $Z_{31}$ and $Z_{32}$ forms a pyridine ring having a plurality of carboxyl groups, and 13 represents 0 or 1;

L2 is a bidentate or tridentate ligand represented by the following general formula (III):

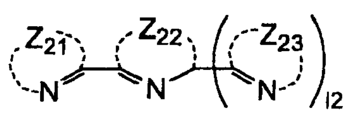

· · · (III)

wherein $Z_{21}$, $Z_{22}$ and $Z_{23}$ independently represent non-metallic atoms forming a 5- or 6-membered ring, said 5- or 6-membered ring optionally has a substituent and optionally forms a condensed ring in combination with another ring, and 12 represents 0 or 1;
L3 is a monodentate or bidentate ligand;
m1 is an integer of 1 to 3;
m2 is an integer of 0 to 2;
m3 is an integer of 0 to 4; and
CI is a counter ion optionally contained in said metal complex dye to neutralize charge thereof.

# Fig. 1

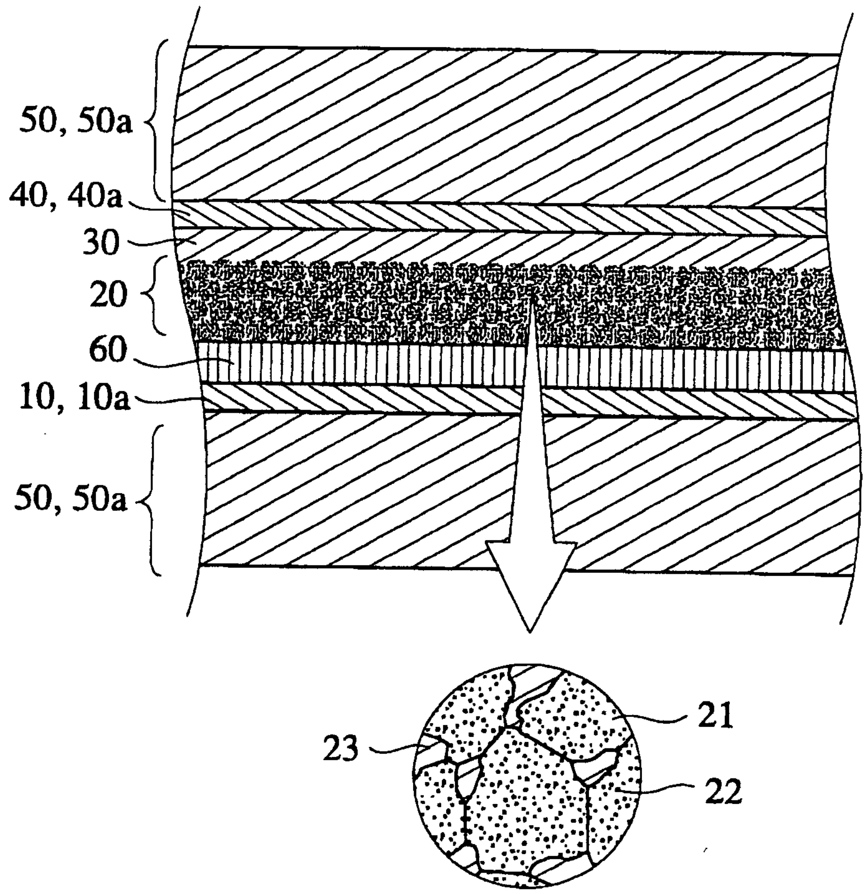


# Fig. 2

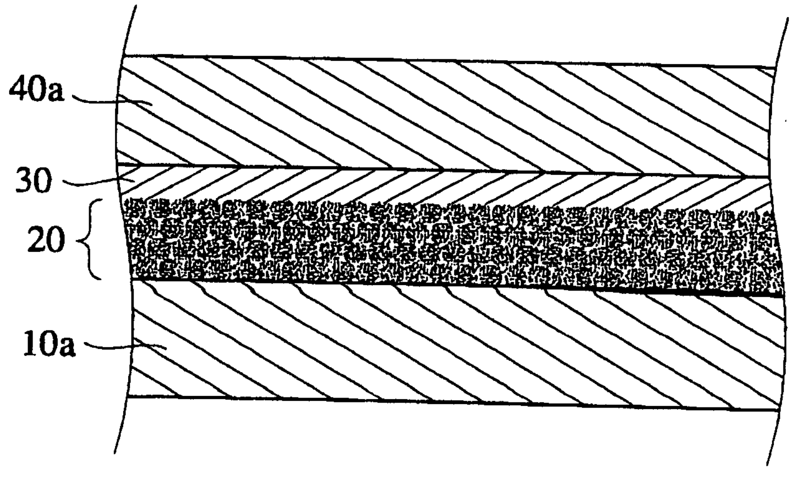

Fig. 3

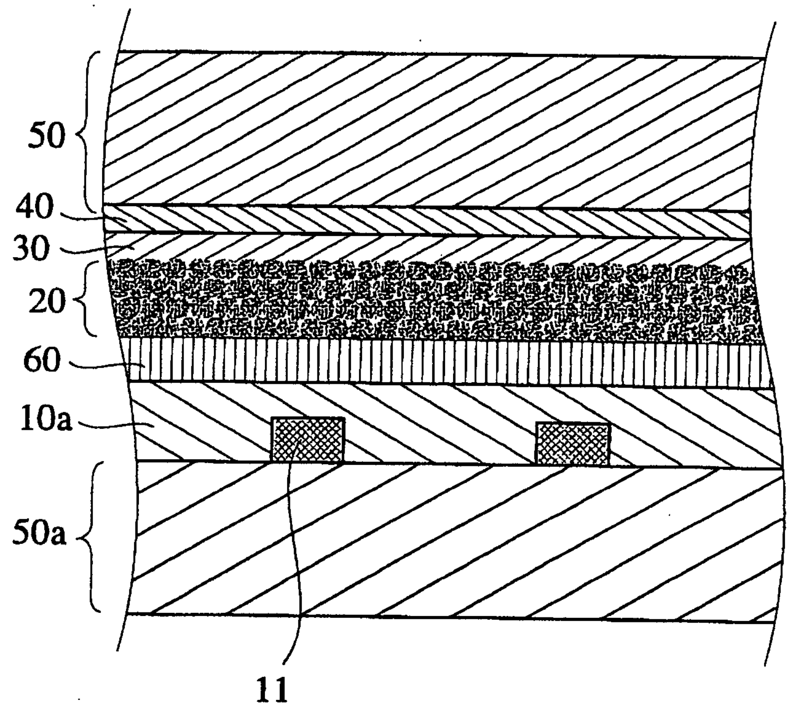


Fig. 4

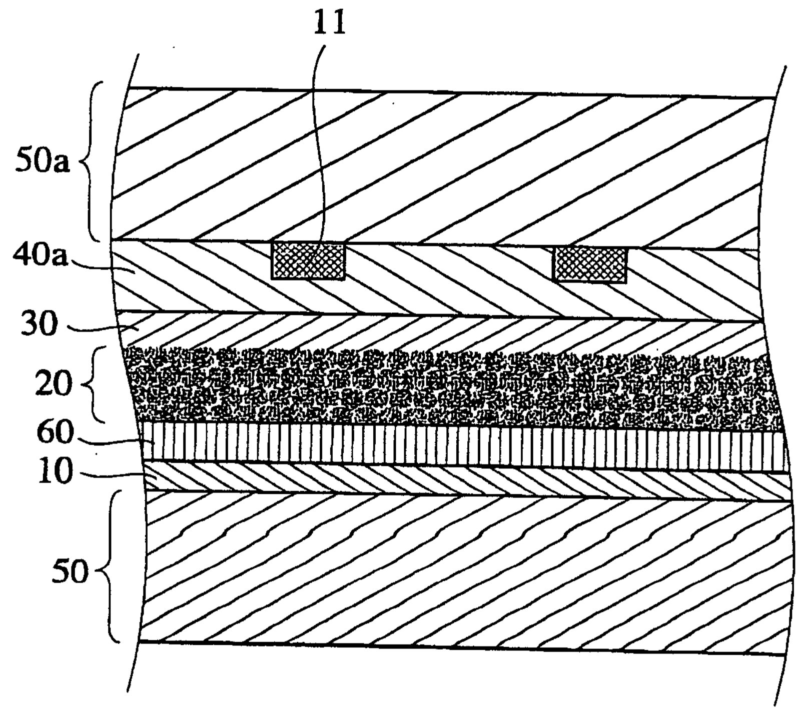

Fig. 5

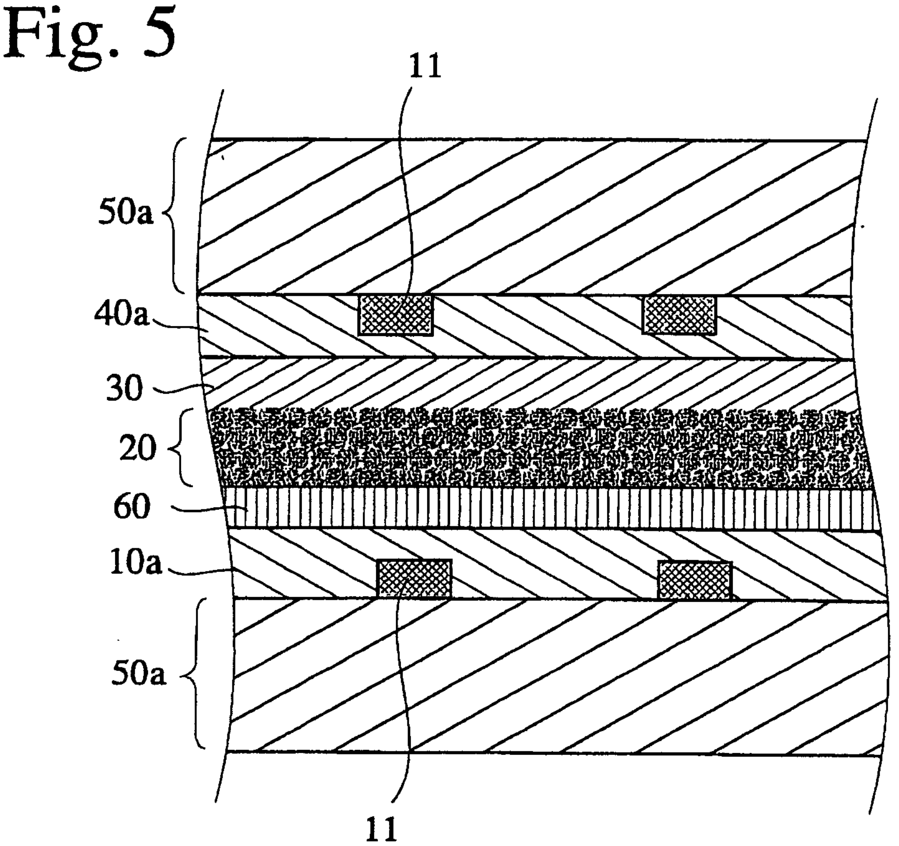


Fig. 6

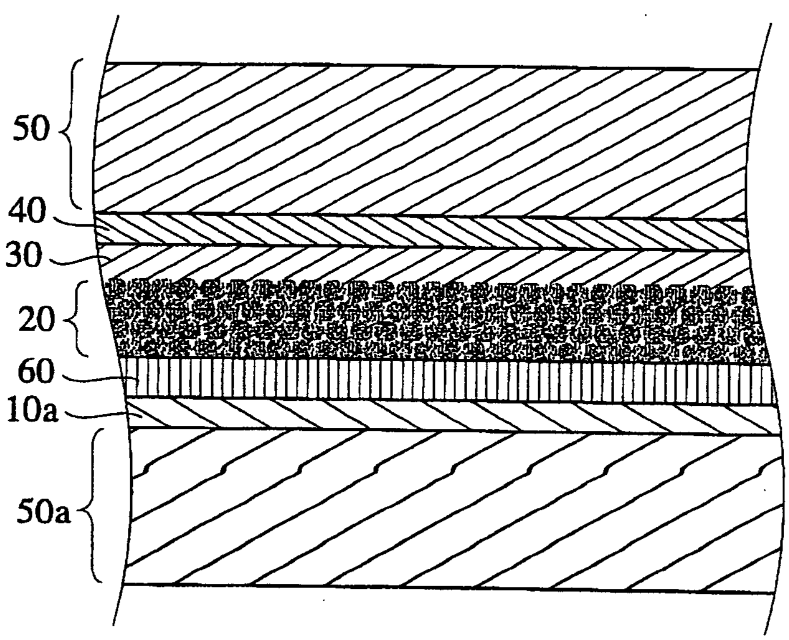

Fig. 7

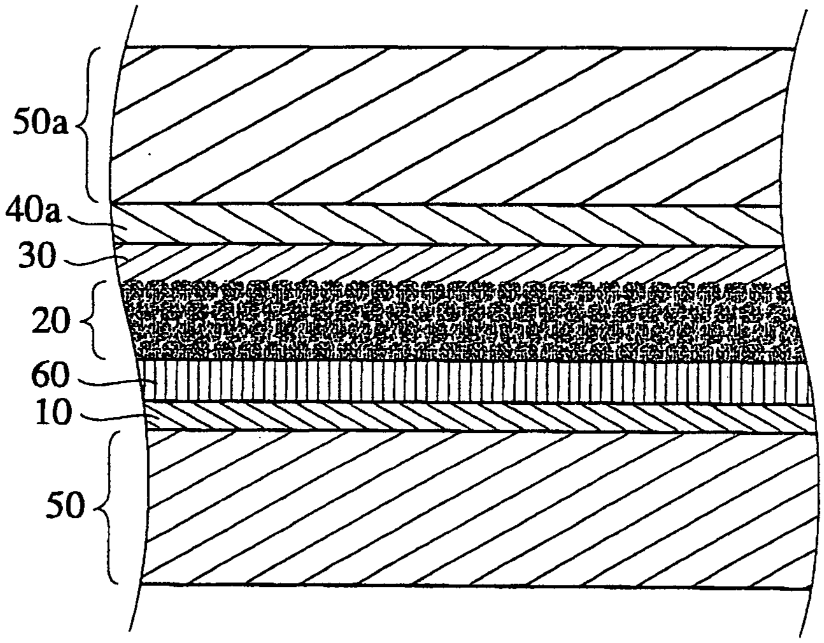


Fig. 8

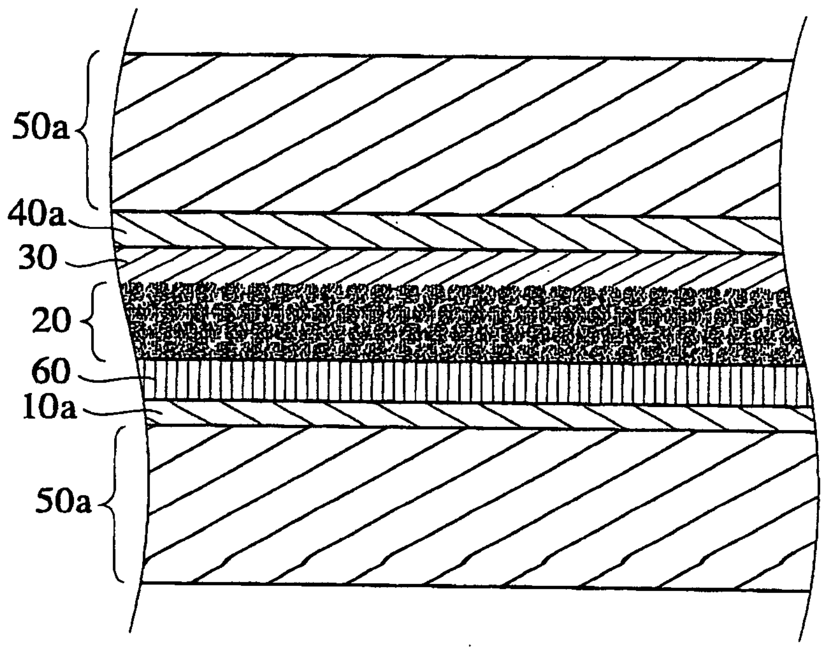

Fig. 9

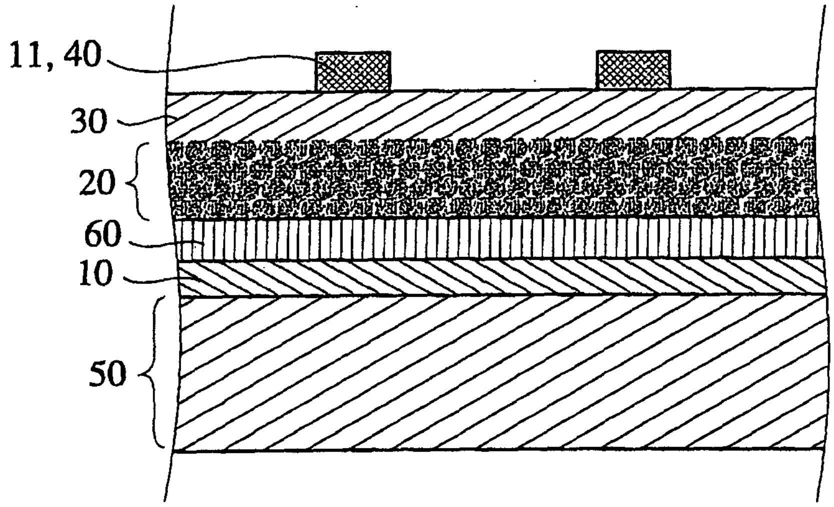


Fig. 10